# FASCICULE DE BREVET EUROPEEN

(11) **EP 4 193 358 B1**
(45) Date de publication et mention de la délivrance du brevet: **16.07.2025**
(21) Numéro de dépôt: 21752059.2
(22) Date de dépôt: 30.07.2021
(51) Int. Cl.: G11C 7/10

(54) **MODULE MEMOIRE RECONFIGURABLE ADAPTE A METTRE EN OEUVRE DES OPERATIONS DE CALCUL**
REKONFIGURIERBARES SPEICHERMODUL ZUR IMPLEMENTIERUNG VON RECHENOPERATIONEN
RECONFIGURABLE MEMORY MODULE DESIGNED TO IMPLEMENT COMPUTING OPERATIONS

(30) Priorité: 04.08.2020 FR 2008272
(43) Date de publication de la demande: 14.06.2023
(73) Titulaire: Commissariat à l'Energie Atomique et aux Energies Alternatives, 75015 Paris (FR); The Board of Trustees of the Leland Stanford Junior University, Stanford, CA 94305-2038 (US)
(72) Inventeur: GAUCHI, Roman, 38054 Grenoble Cedex 09 (FR); VIVET, Pascal, 38054 Grenoble Cedex 09 (FR); MITRA, Subhasish, Menlo Park, CA 94025 (US); CHARLES, Henri-Pierre, 38054 Grenoble Cedex 09 (FR)
(74) Mandataire: Cabinet Beaumont
(86) Numéro de dépôt international: PCT/EP2021/071387
(87) Numéro de publication internationale: WO 2022/029026

(56) Documents cités:
- EP-A1- 3 660 849
- WO-A1-2011/023502
- GUANGMING LU ET AL: "The MorphoSys dynamically reconfigurable system-on-chip", EVOLVABLE HARDWARE, 1999. PROCEEDINGS OF THE FIRST NASA/DOD WORKSHOP O N PASADENA, CA, USA 19-21 JULY 1999, LOS ALAMITOS, CA, USA,IEEE COMPUT. SOC, US, 19 July 1999 (1999-07-19), pages 152 - 160, XP010346235, ISBN: 978-0-7695-0256-4, DOI: 10.1109/EH.1999.785447
- AKYEL KAYA CAN ET AL: "DRC2: Dynamically Reconfigurable Computing Circuit based on memory architecture", 2016 IEEE INTERNATIONAL CONFERENCE ON REBOOTING COMPUTING (ICRC), IEEE, 17 October 2016 (2016-10-17), pages 1 - 8, XP032998975, DOI: 10.1109/ICRC.2016.7738698

## Description

### Domaine technique

La présente description concerne de façon générale le domaine des circuits mémoire, et vise plus particulièrement le domaine des circuits mémoire adaptés à mettre en oeuvre des opérations de calcul.

### Technique antérieure

On a déjà proposé des circuits mémoire adaptés à mettre en oeuvre des opérations de calcul. De tels circuits sont par exemple destinés à coopérer avec un microprocesseur, de façon à décharger le microprocesseur de certaines tâches de calcul.

Le document de GUANGMING LU ET AL: "The MorphoSys dynamically reconfigurable system-on-chip",EVOLVABLE HARDWARE, 1999. PROCEEDINGS OF THE FIRST NASA/DOD WORKSHOP O N PASADENA, CA, USA 19-21 JULY 1999, LOS ALAMITOS, CA, USA,IEEE COMPUT. SOC, US, 19 juillet 1999 (1999-07-19), pages 152-160, décrit un système sur puce qui combine un processeur RISC avec un réseau de cellules reconfigurables.

Le document WO2011/023502 A1 décrit un dispositif de calcul reconfigurable pour traitement d'images.

Il serait souhaitable de pouvoir étendre les fonctionnalités des architectures connues de circuits mémoire adaptés à mettre en oeuvre des opérations de calcul.

### Résumé de l'invention

Pour cela, un mode de réalisation prévoit un module mémoire adapté à mettre en oeuvre des opérations de calcul, le module comportant une pluralité de blocs élémentaires agencés en matrice selon des rangées et des colonnes, dans lequel :
chaque bloc élémentaire comporte un circuit mémoire adapté à mettre en oeuvre des opérations de calcul, et un circuit de transfert configurable ;
le circuit mémoire comprenant une matrice de cellules élémentaires de stockage, des circuits adaptés à mettre en œuvre des calculs au sein ou en périphérie de la matrice de cellules élémentaires de stockage, et un circuit de contrôle adapté à décoder et à commander l'exécution, au sein du circuit mémoire, d'instructions de lecture, d'écriture et/ou de calcul reçues via un bus de distribution;
dans chaque colonne de la matrice, les circuits de transfert configurables des blocs élémentaires de la colonne sont reliés par au moins un bus de liaison ;
chaque circuit de transfert configurable est paramétrable pour transmettre des données issues d'un premier bloc élémentaire émetteur vers un bloc élémentaire récepteur d'une même colonne de blocs élémentaires via ledit au moins un bus de liaison ;
un circuit interne de contrôle (120) est connecté à un port d'entrée-sortie (123) du module comprenant un port d'entrée de données (WDATA), un port de sortie de données (RDATA) et un port d'entrée d'adresses (ADDR), le port d'entrée-sortie du module (123) étant destiné à être connecté à un dispositif extérieur ; et
le circuit interne de contrôle (120) est configuré pour lire au moins un signal d'instruction sur le port d'entrée-sortie (123) du module et paramétrer en conséquence la configuration des circuits de transfert configurables (113), au moins un signal d'instruction permettant de définir la taille des vecteurs opérandes des opérations de calcul mises en oeuvre par le module mémoire.

Le module mémoire comprend en outre un registre de configuration (CSR) mémorisant une information sur la taille courante des vecteurs opérandes, le registre de configuration étant mis à jour après réception d'un signal d'instruction de configuration de taille provenant dudit dispositif extérieur.

Le module mémoire est tel qu'au moins un signal d'instruction pouvant être reçu sur le port d'entrée-sortie du module mémoire code une opération à réaliser entre deux opérandes stockés dans des circuits mémoire différents appartenant respectivement à au moins un premier bloc élémentaire et au moins un deuxième bloc élémentaire, et pour laquelle l'exécution de l'opération comprend une opération de transfert d'un des opérandes dudit au moins un premier bloc élémentaire vers ledit au moins un deuxième bloc élémentaire par l'intermédiaire des circuits de transfert configurables (113) desdits au moins un premier et au moins un deuxième blocs élémentaires et dudit au moins un bus de liaison.

Le module mémoire comprend une pluralité de blocs élémentaires agencés en matrice selon K rangées et P colonnes, avec P entier supérieur ou égal à 1, et K entier supérieur à 1, et dans lequel la taille des vecteurs opérandes peut prendre plusieurs valeurs différentes dont au moins une première taille inférieure à une deuxième taille, et dans lequel, lorsque la première taille est appliquée, un opérande est stocké dans les circuits mémoire d'une unique rangée de blocs élémentaires et dans lequel lorsque la deuxième taille est appliquée un opérande est stocké dans les circuits mémoire de plusieurs rangées de blocs élémentaires, chaque circuit mémoire comprenant une partie de l'opérande de deuxième taille et dans lequel une unique taille de vecteur est appliquée à un moment donné et définie par le registre de configuration.

Selon un mode de réalisation, lorsque la deuxième taille est appliquée, un premier opérande est stocké dans plusieurs premiers blocs élémentaires appartenant à des rangées différentes et un deuxième opérande est stocké dans plusieurs deuxièmes blocs élémentaires appartenant à des rangées différentes, et dans lequel l'opération de transfert du premier opérande comprend plusieurs opérations de transfert indépendantes d'un premier bloc élémentaire vers un deuxième bloc élémentaire.

Selon un mode de réalisation, lorsque la deuxième taille est appliquée, la matrice de blocs élémentaires est organisée en plusieurs groupes de rangées, chaque groupe de rangées étant utilisé pour stocker une même portion d'un opérande donné, et dans lequel les transferts de données entre deux blocs élémentaires d'une même colonne sont possibles uniquement au sein d'un même groupe de rangées.

Selon un mode de réalisation :
dans chaque colonne de la matrice, les circuits de transfert configurables des blocs élémentaires de la colonne sont reliés par des bus de liaison montants et descendants ; et
chaque circuit de transfert configurable est commandable pour transmettre des données entre deux bus de liaison montants, entre deux bus de liaison descendants, et/ou entre le circuit mémoire du bloc élémentaire correspondant et les deux bus de liaison montants et/ou les deux bus de liaison descendants.

Selon un mode de réalisation :
dans chaque colonne de la matrice, les circuits de transfert configurables de deux blocs élémentaires adjacents quelconques de la colonne sont reliés deux à deux par un bus de liaison montant et par un bus de liaison descendant ;
dans chaque bloc élémentaire de chaque colonne de la matrice, à l'exception des blocs élémentaires des première et dernière rangées de la matrice, le circuit de transfert configurable du bloc élémentaire est commandable pour :
   a) transmettre sur un premier port d'entrée de données du circuit mémoire du bloc élémentaire l'un ou l'autre de :
      - un mot de données reçu sur le bus de liaison descendant reliant le bloc élémentaire au bloc élémentaire adjacent de rang inférieur dans la colonne ; et
      - un mot de données reçu sur le bus de liaison montant reliant le bloc élémentaire au bloc élémentaire adjacent de rang supérieur dans la colonne ;
   b) transmettre sur le bus de liaison montant reliant le bloc élémentaire au bloc élémentaire adjacent de rang inférieur dans la colonne l'un ou l'autre de :
      - un mot de données reçu sur un premier port de sortie de données du circuit mémoire du bloc élémentaire ; et
      - un mot de données reçu sur le bus de liaison montant reliant le bloc élémentaire au bloc élémentaire adjacent de rang supérieur dans la colonne ; et
   c) transmettre sur le bus de liaison descendant reliant le bloc élémentaire au bloc élémentaire adjacent de rang supérieur dans la colonne l'un ou l'autre de :
      - un mot de données reçu sur le premier port de sortie de données du circuit mémoire du bloc élémentaire ; et
      - un mot de données reçu sur le bus de liaison descendant reliant le bloc élémentaire au bloc élémentaire adjacent de rang inférieur dans la colonne.

Selon un mode de réalisation, les circuits de transfert des différents blocs élémentaires de la matrice sont connectés au circuit interne de contrôle du module mémoire par l'intermédiaire d'un bus de contrôle.

Selon un mode de réalisation, les circuits mémoire des différents blocs élémentaires de la matrice sont connectés au circuit interne de contrôle par l'intermédiaire d'un bus de distribution.

Selon un mode de réalisation, chaque circuit mémoire comprend un deuxième port d'entrée de données et un deuxième port de sortie de données connectés au bus de distribution.

Selon un mode de réalisation, la largeur du deuxième port d'entrée de données et la largeur du deuxième port de sortie de données sont inférieures ou égales respectivement à la largeur du premier port d'entrée de données et à la largeur du premier port de sortie de données.

Selon un mode de réalisation, la largeur du deuxième port d'entrée de données et la largeur du deuxième port de sortie de données sont strictement inférieures respectivement à la largeur du premier port d'entrée de données et à la largeur du premier port de sortie de données.

Selon un mode de réalisation, chaque circuit mémoire comprend en outre un port d'entrée d'adresses connecté au bus de distribution.

Selon un mode de réalisation, le module mémoire comprend en outre un circuit de régulation globale des accès, connecté au circuit interne de contrôle, le circuit de régulation globale des accès réalisant un suivi des instructions reçues sur le port d'entrée-sortie du module et demandant si nécessaire au circuit interne de contrôle d'attendre avant de requérir l'exécution d'une instruction par un bloc élémentaire ou avant de réaliser un transfert de données entre plusieurs blocs élémentaires via ledit au moins un bus de liaison.

Selon un mode de réalisation, dans chaque bloc élémentaire, le circuit de transfert du bloc comprend des premier, deuxième et troisième multiplexeurs ayant chacun des premier et deuxième ports d'entrée et un port de sortie et dans lequel :
- le premier multiplexeur a ses premier et deuxième ports d'entrée connectés respectivement au bus de liaison descendant reliant le bloc élémentaire au bloc élémentaire adjacent de rang inférieur dans la colonne et au bus de liaison montant reliant le bloc élémentaire au bloc élémentaire adjacent de rang supérieur dans la colonne, et son port de sortie connecté au premier port d'entrée de données du circuit mémoire du bloc élémentaire ;
- le deuxième multiplexeur a ses premier et deuxièmes ports d'entrée connectés respectivement au premier port de sortie de données du circuit mémoire du bloc élémentaire et au bus de liaison montant reliant le bloc élémentaire au bloc élémentaire adjacent de rang supérieur dans la colonne, et son port de sortie connecté au bus de liaison montant reliant le bloc élémentaire au bloc élémentaire adjacent de rang inférieur dans la colonne ; et
- le troisième multiplexeur a ses premier et deuxième ports d'entrée connectés respectivement au premier port de sortie de données du circuit mémoire du bloc élémentaire et au bus de liaison descendant reliant le bloc élémentaire au bloc élémentaire adjacent de rang inférieur dans la colonne, et son port de sortie connecté au bus de liaison descendant reliant le bloc élémentaire au bloc élémentaire adjacent de rang supérieur dans la colonne.

Selon un mode de réalisation, ladite instruction est transmise via le port d'entrée de données et le port d'entrée d'adresses du port d'entrée-sortie du module mémoire.

Un mode de réalisation prévoit un système comprenant un module mémoire selon un mode de réalisation susmentionné et une unité de traitement reliée au module mémoire par l'intermédiaire du port d'entrée-sortie du module mémoire, le module mémoire étant relié à un bus et se comportant comme un composant esclave sur ledit bus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente de façon schématique un exemple d'un mode de réalisation d'un module mémoire adapté à mettre en oeuvre des opérations de calcul ;
la figure 2 représente un exemple de réalisation d'un circuit de transfert vertical d'un bloc élémentaire du module mémoire de la figure 1 ;
la figure 3 illustre des exemples de configurations de fonctionnement du module mémoire de la figure 1 ;
la figure 4A illustre un exemple de mise en oeuvre d'une opération de calcul par le module mémoire de la figure 1 ;
la figure 4B illustre un autre exemple de mise en oeuvre d'une opération de calcul par le module mémoire de la figure 1 ;
la figure 5 représente un exemple de réalisation d'un circuit mémoire d'un bloc élémentaire du module mémoire de la figure 1 ;
la figure 6 illustre un exemple d'un système comprenant un module mémoire du type décrit en relation avec la figure 1 ;
la figure 7 illustre un autre exemple d'un système comprenant des modules mémoires du type décrit en relation avec la figure 1 ;
la figure 8 illustre un exemple d'implémentation des interfaces extérieures entre un module mémoire du type décrit en relation avec la figure 1 et des circuits extérieurs ;
la figure 9 illustre un exemple de format d'instruction pouvant être utilisé pour communiquer entre un circuit extérieur et un module mémoire du type décrit en relation avec la figure 1 ;
la figure 10 détaille un exemple d'implémentation des interfaces d'un circuit de contrôle du module mémoire de la figure 1 ;
la figure 11 détaille un exemple d'implémentation d'un circuit de régulation du module mémoire de la figure 1 ; et
la figure 12 détaille un exemple de fonctionnement d'un circuit de registres de configuration du module mémoire de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des différents éléments des modules mémoire décrits n'a pas été détaillée, la réalisation de ces éléments étant à la portée de la personne du métier à partir des indications de la présente description. En particulier, la réalisation des circuits mémoire adaptés à mettre en oeuvre des opérations de calcul n'a pas été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

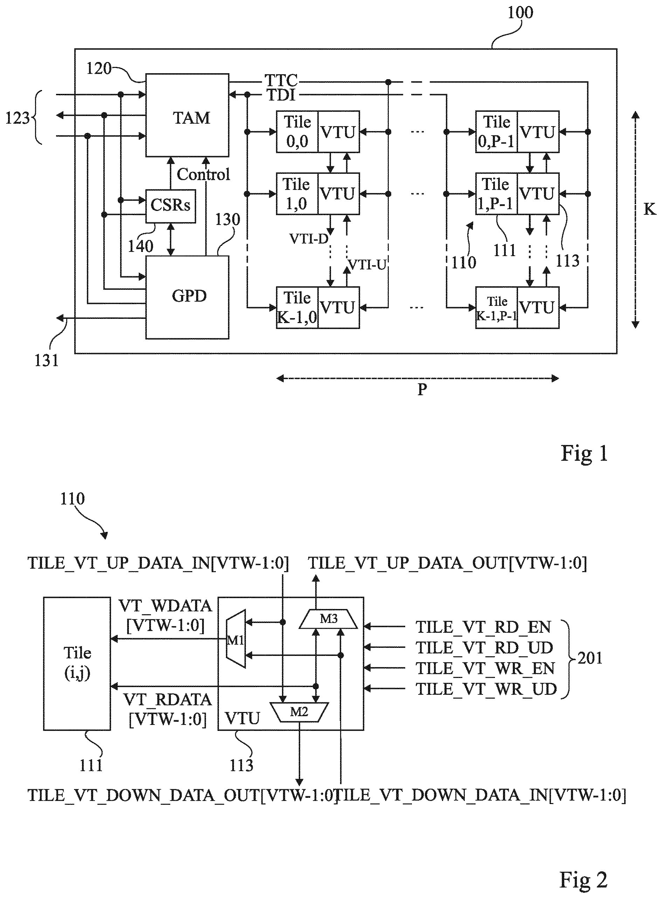

La figure 1 représente de façon schématique un exemple d'un mode de réalisation d'un module mémoire 100 adapté à mettre en oeuvre des opérations de calcul.

Le module 100 comprend une pluralité de blocs élémentaires 110 agencés en matrice selon K rangées et P colonnes, avec P entier supérieur ou égal à 1, de préférence supérieur ou égal à 2, par exemple supérieur ou égal à 3, et K entier supérieur à 1, de préférence supérieur ou égal à 3.

Chaque bloc élémentaire 110 comprend un circuit mémoire 111, également référencé "Tile i,j", avec i entier allant de 0 à K-1 (Tile 0,0 ; Tile 1,0 ; Tile K-1,0) et j entier allant de 0 à P-1 (Tile 0,P-1 ; Tile 1,P-1 ; Tile K-1,P-1) désignant respectivement la position de la rangée et la position de la colonne du bloc élémentaire dans la matrice. Chaque circuit mémoire 111 est adapté à mettre en oeuvre des fonctions de calcul. Plus particulièrement, chaque circuit mémoire 111 est adapté à charger et stocker des données, et à mettre en oeuvre un certain nombre d'opérations logiques et/ou arithmétiques ayant pour opérandes les données stockées dans le circuit mémoire 111. Chaque bloc élémentaire 110 comprend en outre un circuit de transfert vertical 113, également référencé VTU, couplé au circuit mémoire 111 du bloc.

Dans chaque colonne de la matrice, les circuits de transfert configurables 113 de deux blocs élémentaires 110 adjacents quelconques de la colonne sont reliés deux à deux par un bus de liaison montant VTI-U et par un bus de liaison descendant VTI-D. Autrement dit, dans chaque colonne de la matrice, dans chaque bloc élémentaire 110 de rang i de la colonne à l'exception des blocs élémentaires des première (i=0) et dernière (i=K-1) rangées de la matrice, le circuit de transfert vertical 113 du bloc est relié, par exemple connecté, au circuit de transfert vertical 113 du bloc élémentaire 110 de rang i-1 par un bus de liaison montant VTI-U et par un bus de liaison descendant VTI-D, et est relié, par exemple connecté, au circuit de transfert vertical 113 du bloc élémentaire 110 de rang i+1 par un autre bus de liaison montant VTI-U et par un autre bus de liaison descendant VTI-D.

Dans chaque colonne, le circuit de transfert vertical 113 du bloc élémentaire 110 de rang i=0 est relié, par exemple connecté, au circuit de transfert vertical 113 du bloc élémentaire 110 de rang i=1 par un bus de liaison montant VTI-U et par un bus de liaison descendant VTI-D. De plus, dans chaque colonne, le circuit de transfert vertical 113 du bloc élémentaire 110 de rang i=K-1 est relié, par exemple connecté, au circuit de transfert vertical 113 du bloc élémentaire 110 de rang i=K-2 par un bus de liaison montant VTI-U et par un bus de liaison descendant VTI-D.

Selon un aspect des modes de réalisation décrits, dans chaque colonne de la matrice, dans chaque bloc élémentaire 110 de rang i de la colonne, à l'exception des blocs élémentaires 110 des première (i=0) et dernière (i=K-1) rangées de la matrice, le circuit de transfert vertical 113 du bloc est configurable pour :
a) transmettre sur un bus d'écriture de données (non détaillés sur la figure 1) du circuit mémoire 111 du bloc l'un ou l'autre de :
   - un mot de données reçu sur le bus de liaison descendant VTI-D reliant le circuit de transfert vertical 113 du bloc élémentaire 110 au circuit de transfert vertical 113 du bloc élémentaire 110 adjacent de rang i-1 dans la colonne ; et
   - un mot de données reçu sur le bus de liaison montant VTI-U reliant le circuit de transfert vertical 113 du bloc élémentaire 110 au circuit de transfert vertical 113 du bloc élémentaire 110 adjacent de rang i+1 dans la colonne ;
b) transmettre sur le bus de liaison montant VTI-U reliant le circuit de transfert vertical 113 du bloc élémentaire 110 au circuit de transfert vertical 113 du bloc élémentaire 110 adjacent de rang i-1 dans la colonne l'un ou l'autre de :
   - un mot de données reçu sur un bus de lecture de données (non détaillé sur la figure 1) du circuit mémoire 111 du bloc élémentaire ; et
   - un mot de données reçu sur le bus de liaison montant VTI-U reliant le circuit de transfert vertical 113 du bloc élémentaire 110 au circuit de transfert vertical 113 du bloc élémentaire 110 adjacent de rang i+1 dans la colonne ; et
c) transmettre sur le bus de liaison descendant VTI-D reliant le circuit de transfert vertical 113 du bloc élémentaire 110 au circuit de transfert vertical 113 du bloc élémentaire adjacent de rang i+1 dans la colonne l'un ou l'autre de :
   - un mot de données reçu sur le bus de lecture de données du circuit mémoire 111 du bloc élémentaire ; et
   - un mot de données reçu sur le bus de liaison descendant VTI-D reliant le circuit de transfert vertical 113 du bloc élémentaire 110 au circuit de transfert vertical 113 du bloc élémentaire 110 adjacent de rang i-1 dans la colonne.

Dans chaque colonne, le circuit de transfert vertical 113 du bloc élémentaire 110 de rang i=0 est par exemple adapté à :
- transmettre un mot de données reçu sur le bus de lecture de données du circuit mémoire 111 du bloc 110 vers le bus de liaison descendant VTI-D reliant le bloc 110 au circuit de transfert vertical 113 du bloc élémentaire 110 adjacent de rang i=1 ; et/ou
- transmettre sur le bus d'écriture de données du circuit mémoire 111 du bloc 110 un mot de données reçu sur le bus de liaison montant VTI-U reliant le bloc 110 au circuit de transfert vertical 113 du bloc élémentaire 110 adjacent de rang i=1.

Dans chaque colonne, le circuit de transfert vertical 113 du bloc élémentaire 110 de rang i=K-1 est par exemple adapté à :
- transmettre un mot de données reçu sur le bus de lecture de données du circuit mémoire 111 du bloc 110 vers le bus de liaison montant VTI-U reliant le bloc 110 au circuit de transfert vertical 113 du bloc élémentaire 110 adjacent de rang i=K-2 ; et/ou
- transmettre sur le bus d'écriture de données du circuit mémoire 111 du bloc 110 un mot de données reçu sur le bus de liaison descendant VTI-D reliant le bloc 110 au circuit de transfert vertical 113 du bloc élémentaire 110 adjacent de rang i=K-2.

Le module mémoire 100 de la figure 1 comprend en outre un circuit interne 120 de contrôle des blocs élémentaires 110, également référencé TAM sur la figure 1, relié, par exemple connecté, à un port d'entrée-sortie 123 du module. Le port 123 est destiné à être relié, par exemple connecté, à un dispositif extérieur au module, par exemple un microprocesseur. Le port 123 est adapté à recevoir des signaux d'adresses, des signaux de données et/ou des signaux de contrôle fournis par le dispositif extérieur. Le port 123 est de plus adapté à fournir des signaux de données au dispositif extérieur.

Le circuit 120 est notamment adapté à contrôler la configuration des circuits de transfert vertical 113 des blocs élémentaires 110 du module mémoire. Pour cela, un bus de contrôle TTC interne au module 100 relie le circuit 120 à des ports d'entrée de contrôle (non détaillés sur la figure 1) des circuits de transfert vertical 113 des différents blocs élémentaires 110 du module mémoire.

Le circuit 120 est en outre adapté à contrôler la lecture et l'écriture de données, ainsi que la mise en oeuvre d'opérations de calcul, dans les circuits mémoire 111 des blocs élémentaires 110 du module mémoire. Pour cela, un bus de distribution TDI interne au module 100 relie le circuit 120 à des ports d'entrée-sortie de données, d'adresse, et de contrôle (non détaillés sur la figure) des circuits mémoire 111 des différents blocs élémentaires 110 du module mémoire.

Le module 100 comprend en outre un circuit 130 de régulation globale des accès, également référencé GPD sur la figure 1, ainsi qu'un circuit 140 de registres de configuration, également référencé CSRs sur la figure 1.

Le circuit 130 est adapté à ordonnancer les accès aux blocs élémentaires 110 du circuit mémoire, pour éviter des conflits d'adresses lors de l'exécution des instructions reçues depuis l'extérieur du module, via le port 123. Pour cela, le circuit 130 est relié, par exemple connecté, au port 123. Il reçoit l'ensemble des instructions provenant de l'extérieur du module, et est adapté à insérer un ou plusieurs cycles d'attente entre différentes étapes d'une même instruction lorsqu'un conflit potentiel est détecté. Pour cela, le circuit 130 est adapté à envoyer des données de contrôle au circuit 120, via un bus de contrôle référencé Control sur la figure 1. Le circuit 130 est en outre adapté à envoyer des données de contrôle sur un port de sortie 131 du module, destiné à être connecté au dispositif extérieur.

Le circuit 140 est adapté à stocker des données de configuration utilisées par le circuit 120 pour configurer les circuits de transfert vertical 113. Le circuit 140 est lui aussi relié, par exemple connecté, au port d'entrée-sortie 123 du module. Le circuit 120 est adapté à lire des données dans le circuit de registres 140. Le circuit 130 est adapté à lire et écrire des données dans le circuit de registres 140.

La figure 2 représente plus en détail un exemple de réalisation d'un bloc élémentaire 110 du module mémoire de la figure 1. Plus particulièrement, la figure 2 illustre plus en détail un exemple de réalisation du circuit de transfert vertical 113 (VTU) du bloc 110.

Dans cet exemple, le circuit 113 est réalisé à base de multiplexeurs. Plus particulièrement, dans cet exemple, le circuit 113 comprend trois multiplexeurs M1, M2 et M3 ayant chacun deux ports d'entrée et un port de sortie. Chaque multiplexeur est adapté à connecter l'un ou l'autre de ses deux ports d'entrée à son port de sortie, en fonction d'un signal de contrôle appliqué sur une borne de contrôle (non détaillée sur la figure 2) du multiplexeur.

Le multiplexeur M1 a un premier port d'entrée relié, par exemple connecté, à un port d'entrée TILE_VT_UP_DATA_IN du circuit 113, de largeur (nombre de bits transmis en parallèle) VTW, avec VTW entier supérieur ou égal à 2, et un deuxième port d'entrée relié, par exemple connecté, à un port d'entrée TILE_VT_DOWN_DATA_IN de même largeur VTW du circuit 113. Le port d'entrée TILE_VT_UP_DATA_IN est relié, par exemple connecté au bus de transfert descendant VTI-D reliant le bloc 110 au bloc 110 adjacent de rang précédent dans la colonne. Le port d'entrée TILE_VT_DOWN_DATA_IN est relié, par exemple connecté, au bus de transfert montant VTI-U reliant le bloc 110 au bloc 110 adjacent de rang suivant dans la colonne. La sortie du multiplexeur M1 est reliée, par exemple connectée, à un port d'entrée de données VT_WDATA de largeur VTW du circuit mémoire 111 du bloc 110.

Le multiplexeur M2 a un premier port d'entrée relié, par exemple connecté, au port d'entrée TILE_VT_UP_DATA_IN, et un deuxième port d'entrée relié, par exemple connecté, à un port de sortie de données VT_RDATA de largeur VTW du circuit mémoire 111 du bloc 110. La sortie du multiplexeur M2 est reliée, par exemple connectée, à un port de sortie TILE_VT_DOWN_DATA_OUT de largeur VTW du circuit 113. Le port TILE_VT_DOWN_DATA_OUT est relié, par exemple connecté, au bus de transfert descendant VTI-D reliant le bloc 110 au bloc 110 adjacent de rang suivant dans la colonne.

Le multiplexeur M3 a un premier port d'entrée relié, par exemple connecté, au port de sortie de données VT_RDATA du circuit mémoire 111 du bloc 110, et un deuxième port d'entrée relié, par exemple connecté, au port d'entrée TILE_VT_DOWN_DATA_IN du circuit 113. La sortie du multiplexeur M3 est reliée, par exemple connectée, à un port de sortie TILE_VT_UP_DATA_OUT de largeur VTW du circuit 113. Le port TILE_VT_UP_DATA_OUT est relié, par exemple connecté, au bus de transfert montant VTI-U reliant le bloc 110 au bloc 110 adjacent de rang précédent dans la colonne.

Les multiplexeurs M1, M2, M3 sont commandés en fonction de signaux de contrôle transmis via le bus de contrôle TTC sur un port d'entrée de contrôle 201 du circuit 113. Plus particulièrement, dans l'exemple représenté, chaque circuit 113 reçoit sur son port d'entrée de contrôle 201 quatre signaux logiques binaires TILE_VT_RD_EN, TILE_VT_RD_UP, TILE_VT_WR_EN et TILE_VT_RD_UD. La table ci-après récapitule, à titre d'exemple non limitatif, différentes configurations possibles du circuit 113 en fonction de l'état des signaux TILE_VT_RD_EN, TILE VT RD UD, TILE_VT_WR_EN et TILE_VT_WR_UD. Les symboles 0, 1 et X désignent respectivement un état logique bas, un état logique haut, et un état indéterminé (indifféremment bas ou haut) des signaux.

**[Table 1]**

| **TILE_VT_WR_EN** | **TILE_VT_RD_EN** | **TILE_VT_WR_UD** | **TILE_VT_RD_UD** | **Configuration** |
|---|---|---|---|---|
| 0 | 0 | X | X | a) |
| 0 | 1 | X | 0 | b) |
| 0 | 1 | X | 1 | c) |
| 1 | 0 | 0 | X | d) |
| 1 | 0 | 1 | X | e) |
| 1 | 1 | 0 | 0 | f) |
| 1 | 1 | 0 | 1 | g) |
| 1 | 1 | 1 | 0 | h) |
| 1 | 1 | 1 | 1 | i) |

Dans la configuration a), des données sont transmises verticalement par le circuit 113 de haut en bas sur le bus de transfert descendant VTI-D et/ou de bas en haut sur le bus de transfert montant VTI-U, sans interaction avec le circuit mémoire 111.

Dans la configuration b), des données sont lues depuis le bus de transfert descendant VTI-D via le port d'entrée TILE_VT_UP_DATA_IN du circuit 113 et écrites dans le circuit mémoire 111 via le bus d'entrée de données VT_WDATA du circuit 111.

Dans la configuration c), des données sont lues depuis le bus de transfert montant VTI-U via le port d'entrée TILE_VT_DOWN_DATA_IN du circuit 113 et écrites dans le circuit mémoire 111 via le bus d'entrée de données VT_WDATA du circuit 111.

Dans la configuration d), des données sont lues dans le circuit mémoire 111 via le bus de sortie de données VT_RDATA du circuit 111, et écrites sur le bus de transfert descendant VTI-D via le port de sortie TILE_VT_DOWN_DATA_OUT du circuit 113.

Dans la configuration e), des données sont lues dans le circuit mémoire 111 via le bus de sortie de données VT_RDATA du circuit 111, et écrites sur le bus de transfert montant VTI-U via le port de sortie TILE_VT_UP_DATA_OUT du circuit 113.

Dans la configuration f), des données sont lues depuis le bus de transfert descendant VTI-D via le port d'entrée TILE_VT_UP_DATA_IN du circuit 113 et écrites dans le circuit mémoire 111 via le bus d'entrée de données VT_WDATA du circuit 111, et des données sont lues dans le circuit mémoire 111 via le bus de sortie de données VT_RDATA du circuit 111, et écrites sur le bus de transfert descendant VTI-D via le port de sortie TILE_VT_DOWN_DATA_OUT du circuit 113.

Dans la configuration g), des données sont lues depuis le bus de transfert montant VTI-U via le port d'entrée TILE_VT_DOWN_DATA_IN du circuit 113 et écrites dans le circuit mémoire 111 via le bus d'entrée de données VT_WDATA du circuit 111, et des données sont lues dans le circuit mémoire 111 via le bus de sortie de données VT_RDATA du circuit 111, et écrites sur le bus de transfert descendant VTI-D via le port de sortie TILE_VT_DOWN_DATA_OUT du circuit 113.

Dans la configuration h), des données sont lues depuis le bus de transfert descendant VTI-D via le port d'entrée TILE_VT_UP_DATA_IN du circuit 113 et écrites dans le circuit mémoire 111 via le bus d'entrée de données VT_WDATA du circuit 111, et des données sont lues dans le circuit mémoire 111 via le bus de sortie de données VT_RDATA du circuit 111, et écrites sur le bus de transfert montant VTI-U via le port de sortie TILE_VT_UP_DATA_OUT du circuit 113.

Dans la configuration i), des données sont lues depuis le bus de transfert montant VTI-U via le port d'entrée TILE_VT_DOWN_DATA_IN du circuit 113 et écrites dans le circuit mémoire 111 via le bus d'entrée de données VT_WDATA du circuit 111, et des données sont lues dans le circuit mémoire 111 via le bus de sortie de données VT_RDATA du circuit 111, et écrites sur le bus de transfert montant VTI-U via le port de sortie TILE_VT_UP_DATA_OUT du circuit 113.

Les circuits de transfert 113 des blocs 110 des première (i=0) et dernière (i=K-1) rangées de la matrice peuvent éventuellement être simplifiés. A titre d'exemple, dans les première et dernière rangées de la matrice, les multiplexeurs M1, M2 et M3 peuvent être omis. Plus particulièrement, dans chaque circuit 113 de la première rangée de la matrice, le port d'entrée TILE_VT_UP_DATA_IN et le port de sortie TILE_VT_UP_DATA_OUT peuvent être omis, et les ports d'entrée TILE_VT_DOWN_DATA_IN et de sortie TILE_VT_DOWN_DATA_OUT peuvent être directement reliés, par exemple connectés, respectivement au port d'entrée de données VT_WDATA et au port de sortie de données VT_RDATA du circuit mémoire 111 du bloc 110 correspondant. De façon similaire, dans chaque circuit 113 de la dernière rangée de la matrice, le port d'entrée TILE_VT_DOWN_DATA_IN et le port de sortie TILE_VT_DOWN_DATA_OUT peuvent être omis, et les ports d'entrée TILE_VT_UP_DATA IN et de sortie TILE_VT_UP_DATA OUT peuvent être directement reliés, par exemple connectés, respectivement au port d'entrée de données VT_WDATA et au port de sortie de données VT_RDATA du circuit mémoire 111 du bloc 110 correspondant.

A titre de variante, dans au moins l'une des première (i=0) et dernière (i=K-1) rangées de la matrice, les circuits de transfert 113 ont les mêmes fonctionnalités que dans les autres rangées, de façon à permettre des transferts de données vers et depuis un circuit de routage (non détaillé) disposé en pied ou en tête de colonne, permettant par exemple de réaliser des transferts de données horizontaux (d'une colonne à une autre) dans la matrice.

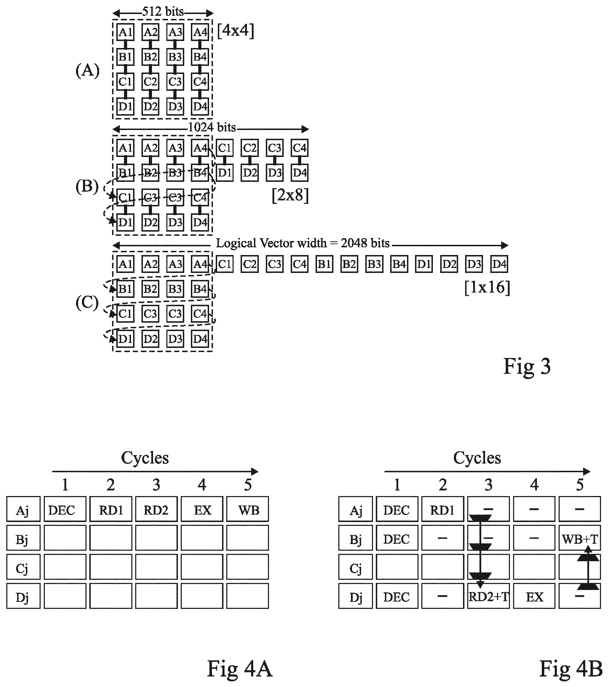

La figure 3 illustre des exemples possibles de configuration de fonctionnement du module mémoire 100 de la figure 1.

On considère ici, à titre d'exemple illustratif, une matrice de K=4 rangées et P=4 colonnes de blocs élémentaires 110.

Sur la figure 3, pour plus de clarté, on a désigné par A1, A2, A3 et A4 les blocs élémentaires 110 de la rangée de rang i=0 et respectivement des colonnes de rangs j=0, j=1, j=2 et j=3, par B1, B2, B3 et B4 les blocs élémentaires 110 de la rangée de rang i=1 et respectivement des colonnes de rangs j=0, j=1, j=2 et j=3, par C1, C2, C3 et C4 les blocs élémentaires 110 de la rangée de rang i=2 et respectivement des colonnes de rangs j=0, j=1, j=2 et j=3, et par D1, D2, D3 et D4 les blocs élémentaires 110 de la rangée de rang i=3 et respectivement des colonnes de rangs j=0, j=1, j=2 et j=3.

Le cadre en trait interrompu sur la figure 3 représente l'emplacement physique des blocs élémentaire 110 du module mémoire 100.

Comme l'illustre la figure 3, un avantage du module mémoire 100 de la figure 1 est que l'on peut aisément, par l'intermédiaire du circuit de contrôle 120 et des circuits de transfert vertical 113, reconfigurer virtuellement la matrice de blocs élémentaires 110 de façon à étendre la taille maximale des vecteurs horizontaux pouvant être traités par le module mémoire, notamment pour la mise en oeuvre d'opérations de calcul.

Sur la figure 3, on a représenté par une flèche bidirectionnelle horizontale la taille maximale (512 bits ; 1024 bits ; Logical Vector width = 2048 bits) des vecteurs horizontaux pouvant être traités par le module mémoire 100, et par un trait gras vertical les liaisons de transfert vertical activées entre blocs élémentaire adjacents d'une même colonne de la matrice. Dans cet exemple, la largeur maximale VTW des mots pouvant être traités par les circuits de transfert 113 est considérée égale à 128 bits. Les modes de réalisation décrits ne se limitent bien entendu pas à ce cas particulier.

Sur la figure 3, trois configurations distinctes de fonctionnement (A), (B) et (C) ont été représentées.

Dans la configuration (A), les liaisons de transfert vertical entre les différentes rangées sont toutes actives. Autrement dit, chaque circuit de transfert vertical 113 peut transférer verticalement des données sur les bus de transfert montant VTI-U et/ou descendant VTI-D auxquels il est connecté. Dans ce cas, la configuration logique de la matrice de blocs élémentaires coïncide avec sa configuration physique, c'est-à-dire que la largeur maximale des vecteurs pouvant être traités par le module mémoire est égale à P*VTW, soit 4*128=512 bits dans cet exemple.

Dans la configuration (B), les rangées de la matrice sont réparties par paires de deux rangées adjacentes entre lesquelles les liaisons de transfert vertical sont actives. Les liaisons de transfert vertical entre deux rangées adjacentes de paires différentes sont en revanche inactives. Plus particulièrement, dans l'exemple représenté, les liaisons de transfert vertical entre les deuxièmes et troisièmes rangées de la matrice sont désactivées. Les liaisons de transfert vertical entre les premières et deuxièmes rangées et les liaisons de transfert vertical entre les troisièmes et quatrièmes rangées sont en revanche actives. Dans ce cas, d'un point de vue logique, un même vecteur horizontal peut s'étendre dans les premières et troisièmes rangées, ou dans les deuxièmes et quatrièmes rangées. Ainsi, la largeur maximale des vecteurs pouvant être traités par le module mémoire est égale à 2*P*VTW, soit 2*4*128=1024 bits dans cet exemple.

Dans la configuration (C), toutes les liaisons de transfert vertical entre rangées adjacentes sont désactivées. Dans ce cas, d'un point de vue logique, un même vecteur horizontal peut s'étendre dans l'ensemble des rangées de la matrice. Ainsi, la largeur maximale des vecteurs pouvant être traités par le module mémoire est égale à K*P*VTW, soit 4*4*128=2048 bits dans cet exemple.

Ainsi, l'architecture proposée permet de redimensionner dynamiquement la largeur des vecteurs pendant le fonctionnement du module en fonction du type de calculs à réaliser. La mise en correspondance des adresses logiques et des adresses physiques est assurée par le circuit de contrôle 120. A chaque opération, les opérandes et résultats de calcul restent alignés verticalement.

On notera que les modes de réalisation ne se limitent pas à l'exemple d'implémentation du circuit de transfert vertical 113 décrit en relation avec la figure 2.

En outre, les modes de réalisation ne se limitent pas aux exemples de bus de liaisons montant VTI-U et descendant VTI-D décrits précédemment en relation avec l'exemple de circuit de transfert 113. De façon générale, un circuit de transfert 113 permet d'échanger des données avec d'autres circuits de transfert de la même colonne de blocs élémentaires 110 via au moins un bus vertical. Dans l'exemple décrit précédemment, une suite de bus de liaisons « locaux » sont reliés par l'intermédiaire des circuits de transfert 113. Selon un mode de réalisation alternatif, il serait possible d'avoir un bus de liaison « partagé » montant et un bus de liaison « partagé » descendant. Chaque bloc élémentaire 110 d'une colonne est alors relié à chacun des bus de liaison partagés par l'intermédiaire d'un circuit de transfert 113. Chaque circuit de transfert permet l'écriture ou la lecture de données sur chaque bus de liaison partagé en fonction de signaux de commande reçus via le bus de contrôle TTC.

Alternativement, il est possible de prévoir un unique bus de liaison par colonne de bloc élémentaire 110, le bus de liaison étant alors apte à transmettre des données vers le haut ou le bas de la colonne. Il est également possible d'envisager plusieurs bus montants ou descendants par colonne. Selon le nombre de bus de liaisons partagés ou locaux, les possibilités de réalisation de transfert de données sont bien entendu différentes et les circuits 120 et 130 doivent être adaptés en conséquence. Les figures 4A et 4B illustrent, à titre d'exemple, le déroulement d'une opération de calcul décomposée en cinq étapes élémentaires successives d'un cycle chacune, à savoir : une étape DEC de décodage d'une instruction reçue, une étape RD1 de lecture d'une première donnée opérande, une étape RD2 de lecture d'une deuxième donnée opérande, une étape EX d'exécution de l'opération de calcul ayant pour opérandes les données lues aux étapes RD1 et RD2, et une étape WB d'écriture du résultat de l'opération.

Dans l'exemple de la figure 4A, les données opérandes sont contenues dans un ou plusieurs blocs élémentaires 110 d'une même rangée de la matrice, la première rangée (i=0) dans l'exemple représenté. Le résultat du calcul est réécrit dans ces mêmes blocs élémentaires 110.

L'instruction est reçue par le ou les circuits mémoire 111 correspondants via le bus TDI, et décodée à l'étape DEC au sein de ces circuits mémoire. La suite de l'opération (étapes RD1, RD2, EX et WB) est mise en oeuvre au sein de ces mêmes circuits mémoire 111.

Dans l'exemple de la figure 4B, la première donnée opérande est contenue dans un ou plusieurs blocs élémentaires 110 d'une première rangée de la matrice (la rangée de rang i=0 dans l'exemple représenté), et la deuxième donnée opérande est contenue dans un ou plusieurs blocs élémentaires 110 d'une deuxième rangée de la matrice (la rangée de rang i=3 dans l'exemple représenté), alignés verticalement avec les blocs élémentaires 110 de la première donnée opérande. Le résultat de l'opération est réécrit dans un ou plusieurs blocs élémentaires 110 d'une troisième rangée de la matrice (la rangée de rang i=1 dans l'exemple représenté), alignés verticalement avec les blocs élémentaires 110 des première et deuxième données opérandes.

L'instruction est reçue par l'ensemble des circuits mémoire 111 concernés via le bus TDI, et décodée à l'étape DEC au sein de ces circuits mémoire. L'étape RD1 est réalisée dans le ou les circuits mémoire 111 de la rangée de rang i=0 contenant la première donnée opérande. L'étape RD2 est réalisée dans le ou les circuits mémoire 111 de la rangée de rang i=3 contenant la deuxième donnée opérande. En parallèle de l'étape RD2 (lors du même cycle), la première donnée opérande lue à l'étape RD1 est transférée verticalement, via les bus de transfert VTI et les circuits de transfert 113, vers les bocs élémentaires 110 correspondants de la rangée contenant la deuxième donnée opérande (la rangée de rang i=3 dans cet exemple). L'opération de calcul proprement dite (étape EX) est mise en oeuvre au cycle suivant, au sein des circuits mémoire 111 de la rangée de rang i=3. Au cycle suivant, le résultat de l'opération est transféré verticalement vers la rangée destination via les bus de transfert VTI et les circuits de transfert 113, et écrit dans les circuits mémoire 111 correspondants de la rangée destination (étape WB).

Le contrôle des transferts verticaux mis en oeuvre pendant l'exécution est assuré par le circuit 120, via le bus TTC.

Le circuit de régulation 130 prédit les mouvements de données verticaux entre les vecteurs en fonction du flux d'instructions reçu, et envoie des signaux de contrôle globaux au circuit 120 en vue de contrôler les circuits de transfert 113 des blocs élémentaires 110. En particulier, le circuit de régulation 130 s'assure de la disponibilité des données pour chaque étape de la séquence d'instructions à mettre en oeuvre. Des risques de conflits peuvent notamment se produire lorsque des instructions différentes cherchent à modifier une même donnée, notamment dans les situations suivantes :
- lorsqu'une instruction cherche à utiliser un résultat qui n'a pas encore été calculé (lecture après écriture) ;
- lorsqu'une instruction cherche à écrire un résultat dans un emplacement destination avant que ce dernier n'ait été lu (écriture après lecture) ; et
- lorsqu'une instruction cherche à écrire un résultat de calcul à une destination avant que cette destination n'ait été écrite par une instruction précédente (écriture après écriture).

Pour prévenir de tels conflits, le circuit de régulation 130 peut notamment si nécessaire insérer un ou plusieurs cycles d'attente entre différentes étapes d'une même opération de calcul.

On notera que dans l'architecture décrite en relation avec la figure 1, un transfert de données vertical descendant et un transfert de données vertical montant peuvent être réalisés simultanément (lors d'un même cycle) dans une même colonne de la matrice. En revanche, si deux instructions cherchent à réaliser un transfert de données vertical dans la même direction, lors d'un même cycle, un conflit peut se produire. Le circuit de régulation 130 peut insérer un ou plusieurs cycles d'attente entre les étapes de transfert vertical des deux instructions pour éviter un tel conflit. De façon similaire, le circuit de régulation 130 s'assure que tous les transferts verticaux en attente sont effectués avant de modifier la configuration globale virtuelle de la matrice de blocs élémentaires tel que décrit en relation avec la figure 3.

Pour piloter le module mémoire 100 depuis un dispositif extérieur, par exemple un microprocesseur, un jeu d'instructions dédié peut être défini, par exemple un jeu d'instructions du type décrit dans la demande de brevet EP3503103A1 précédemment déposée par le demandeur.

Les paramètres utilisés pour reconfigurer l'agencement logique des blocs élémentaires 110 du module 100 peuvent être mémorisés dans le circuit de registres de configuration 140. Une instruction spécifique peut être définie pour écrire ou lire des paramètres de configuration dans le circuit 140 depuis l'extérieur du module 100, via le port 123.

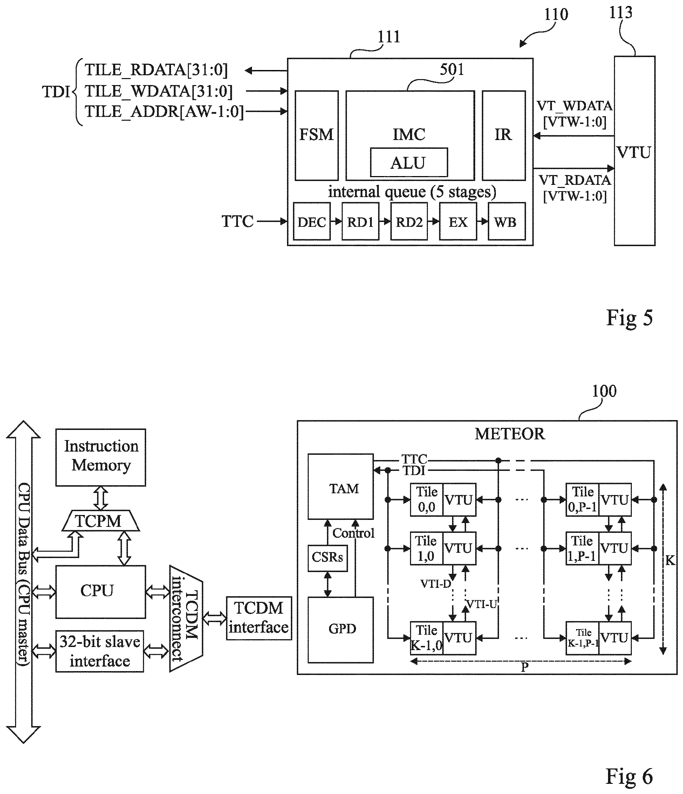

La figure 5 représente un exemple de réalisation d'un bloc élémentaire 110 du module mémoire 100 de la figure 1. La figure 5 détaille plus particulièrement, sous forme de blocs fonctionnels, un exemple de réalisation du circuit mémoire 111 du bloc 110.

Dans cet exemple, le circuit mémoire 111 est un circuit mémoire de type IMC (de l'anglais "In Memory Computing" - calcul en mémoire). Il comprend une matrice 501 de cellules élémentaires de stockage (non détaillées sur la figure), et des éléments de calcul représentés sous la forme d'un bloc référencé ALU sur la figure 5, permettant de mettre en oeuvre des opérations de calcul logique et/ou arithmétique directement au sein de la matrice de cellules de stockage 501, par exemple tel que décrit dans la demande de brevet EP3252774A1 précédemment déposée par le demandeur.

Le circuit mémoire 111 de la figure 5 comprend en outre un circuit de contrôle FSM adapté à décoder et à commander l'exécution d'instructions de lecture, d'écriture et/ou de calcul reçues via le bus TDI.

Le circuit mémoire 111 de la figure 5 comprend de plus un registre interne IR adapté par exemple à stocker des résultats partiels d'opération, de façon à limiter les accès en lecture/écriture à la matrice 501 et à éviter ou limiter l'introduction de cycles d'attente par le circuit de régulation 130 pour gérer les conflits entre opérations. Ceci permet d'éviter des ralentissements du processeur et de maintenir un débit d'instruction optimal.

Dans cet exemple, le circuit mémoire 111 comprend, connecté au bus TDI, un port d'entrée-sortie de signaux, comprenant notamment :
- un port de sortie de données TILE _RDATA ;
- un port d'entrée de données TILE_WDATA ; et
- un port d'entrée de signaux d'adresse TILE_ADDR.

Dans l'exemple représenté, les ports TILE _RDATA et TILE_WDATA ont chacun une largeur de 32 bits. Les modes de réalisation décrits ne se limitent bien entendu pas à ce cas particulier. A titre d'exemple, la largeur des ports TILE _RDATA et TILE _WDATA est inférieure ou égale, et de préférence strictement inférieure, à la largeur VTW (128 bits dans l'exemple de la figure 3) des ports VT_RDATA et VT_WDATA connectés au circuit de transfert vertical 113 du bloc 110. L'intérêt d'avoir des bus de liaison VTI d'échange de données présentant une largeur VTW élevée, plus grande que la largeur des bus de données faisant partie du bus TDI présentant une largeur correspondant à la taille des ports TILE _RDATA et TILE_WDATA est de permettre un transfert vertical rapide entre deux circuits mémoire de blocs élémentaires différents. La présence de ces bus de liaison « directes » permet de transférer d'un coup, lors d'un cycle, l'intégralité d'un opérande stocké dans un circuit mémoire quand la largeur VTW correspond à la largeur de l'opérande. En l'absence de ce bus de liaison « large » et dédié au transfert d'opérandes, le seul moyen de transférer un opérande serait d'utiliser le bus TDI, de largeur plus petite, et il faudrait en pratique découper l'opérande en plusieurs morceaux et le transfert prendrait plusieurs cycles. Ainsi, par rapport à des systèmes classiques où des mémoires indépendantes sont reliées par des bus système souvent de petite taille, le regroupement des circuits mémoire dans une matrice telle que dans l'invention permet d'optimiser le transfert de données entre mémoires.

Le port d'entrée-sortie connecté au bus TDI peut de plus comporter des bornes d'entrée supplémentaires adaptées à recevoir des signaux de contrôle et/ou d'horloge.

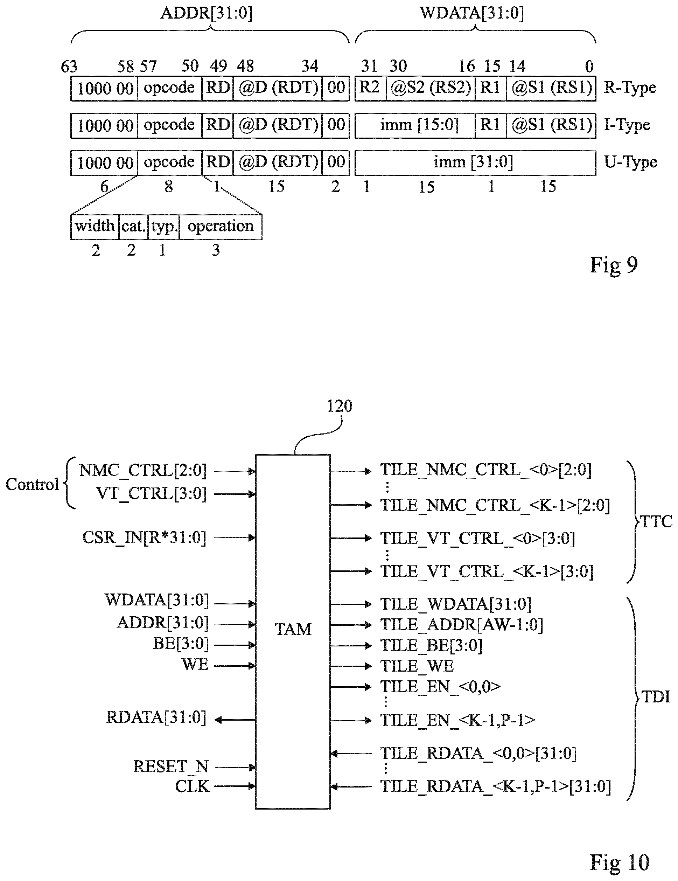

Le circuit mémoire 111 peut en outre comporter des bornes d'entrée, non détaillées sur la figure, connectées au bus TTC. Les signaux reçus du bus TTC permettent en pratique de commander d'une part le transfert des données via le circuit de transfert 113, tel que décrit précédemment, et d'autre part de commander les opérations de calcul dans le circuit mémoire 111. Les signaux du bus TTC arrivant sur un circuit mémoire sont par exemple les signaux TILE_NMC_CTRL représentés en figure 10. Ces signaux permettent de configurer le circuit mémoire dans un mode « classique » ou « calcul ». Le mode classique de fonctionnement du circuit mémoire correspondant aux opérations classiques de lecture/écriture de données dans la mémoire à partir des signaux de commande classiques reçus sur le bus TDI. Le mode « calcul » (souvent désigné par « smart memory » en anglais) correspond à l'activation de fonctionnalités de calcul dans le circuit mémoire 111. Pour ce faire, on utilise par exemple une machine d'état FSM pour contrôler l'exécution des opérations notamment le contenu d'un ensemble de bascules « queue » (décrites ci-après) et l'utilisation du registre interne IR, ainsi que toutes fonctions de calcul interne et/ou périphérique du bloc mémoire 501 / ALU. En mode calcul, les informations concernant le type d'instructions, les opérandes sont transmis dans cet exemple via le bus TDI et interprété lors de l'opération de décodage de l'instruction.

Dans l'exemple représenté, le circuit mémoire 111 comprend en outre une série de bascules mémoires adaptées à temporiser/séquencer une suite d'opérations à exécuter. Dans l'exemple représenté, cette suite de bascules, aussi appelée queue (internal queue (5 stages)), sépare la suite d'opérations en cinq étages correspondant par exemple aux cinq étapes successives DEC, RD1, RD2, EX et WB décrites en relation avec les figures 4A et 4B.

On notera que les modes de réalisation décrits ne se limitent pas au cas où le circuit mémoire 111 est un circuit de type IMC. Plus généralement, les modes de réalisation décrits peuvent être adaptés à tous types de circuits mémoire adaptés à mettre en oeuvre des opérations de calcul, par exemple des circuits de type NMC (de l'anglais "Near Memory Computing" - calcul à proximité de la mémoire), dans lesquels des circuits de calcul sont intégrés en périphérie immédiate de la matrice de cellules élémentaires du circuit mémoire. Des exemples de circuits de type NMC sont décrits dans la demande de brevet français 2001243.

Le module mémoire 100 de la figure 1 peut être intégré dans un système standard (non représenté) comportant un processeur, par exemple de façon similaire à ce qui a été décrit dans la demande de brevet EP3503103A1 susmentionnée.

A titre d'exemple, le module mémoire 100 peut être intégré dans un système à faible latence (non représenté), directement couplé, par exemple connecté, au processeur, et fonctionner à la fréquence du processeur. Le processeur exécute par exemple ses propres instructions provenant d'une mémoire d'instructions du système. Le module 100 peut recevoir des instructions et des données directement du processeur, ou d'un bus système connecté au processeur. De façon similaire, le module 100 peut envoyer des données directement au processeur, ou sur le bus système.

La figure 6 représente un exemple de réalisation d'un tel système. Dans cet exemple, le module mémoire 100 est également désigné par la référence METEOR. Les ports 123 et 131 du module mémoire, non détaillés sur la figure 6, sont connectés à un circuit d'interface extérieur désigné par la référence "TCDM interface", lui-même relié, par l'intermédiaire d'un multiplexeur d'interconnexion désigné par la référence "TCDM interconnect", à un processeur CPU. Le processeur CPU est connecté, à un bus maître désigné par la référence "CPU Data Bus (CPU master)". Le multiplexeur d'interconnexion relie en outre un circuit d'interface esclave, par exemple un circuit d'interface 32 bits, désigné sur la figure par la référence "32-bit slave interface", au circuit d'interface "TCDM interface". Le circuit d'interface esclave est connecté au bus maitre. Le processeur CPU est en outre relié, par l'intermédiaire d'un multiplexeur TCPM, à une mémoire d'instruction désignée par la référence "Instruction Memory". Le multiplexeur TCPM relie en outre le bus maitre à la mémoire d'instruction.

A titre de variante, le module mémoire 100 de la figure 1 peut être intégré dans un système distribué (non représenté) comme unité de co-traitement connectée au bus système et fonctionnant en parallèle du processeur, à une fréquence distincte de celle du processeur. Le système peut notamment comporter un ou plusieurs accélérateurs matériels connectés au bus système et comportant chacun un unique module 100, ou plusieurs modules 100 reliés à un même bus local permettant de mettre en oeuvre des calculs distribués.

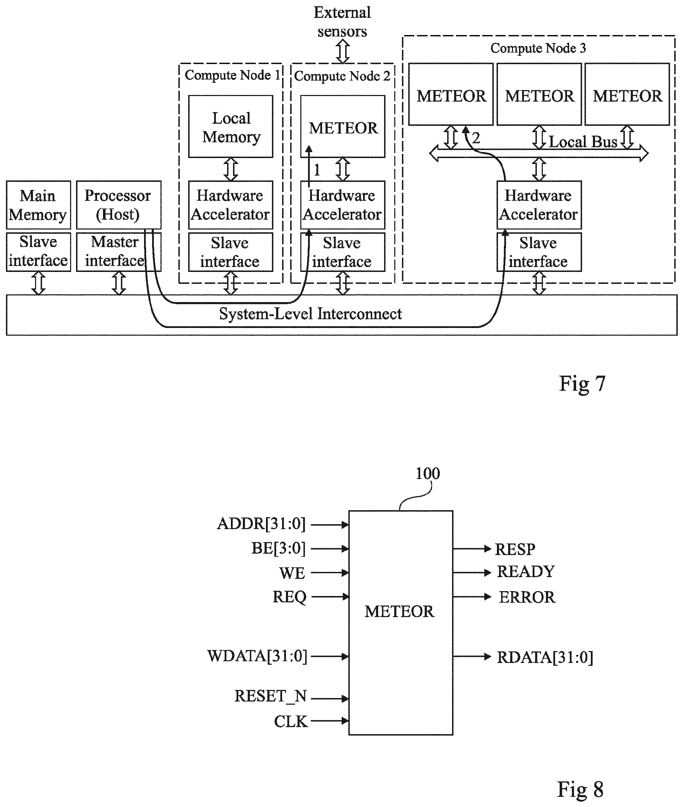

La figure 7 représente un exemple de réalisation d'un tel système. Le système de la figure 7 comprend un processeur hôte désigné par la référence "Processor (Host)" et relié, par l'intermédiaire d'un circuit d'interface maître désigné par la référence "Master interface", à un bus système désigné par la référence "System-Level Interconnect". Le système comprend en outre une mémoire principale désignée par la référence "Main Memory", reliée au bus système par un circuit d'interface esclave désigné par la référence "Slave interface". Dans l'exemple représenté, le système comprend des premier, deuxième et troisième noeuds de calcul référencés respectivement "Compute Node 1", "Compute Node 2" et "Compute Node 3". Le premier noeud de calcul comprend une mémoire locale désignée par la référence "Local Memory", reliée à un circuit d'accélération matérielle désigné par la référence "Hardware Accelerator". Le premier noeud de calcul comprend en outre un circuit d'interface esclave "Slave interface" reliant le circuit d'accélération matérielle au bus système. Le deuxième noeud de calcul est similaire au premier noeud de calcul, à ceci près que la mémoire locale est remplacée par un module mémoire METEOR du type décrit en relation avec la figure 1. Le deuxième noeud de calcul peut en outre être relié à des capteurs extérieurs, non détaillés, désignés par la référence "External sensors". Le troisième noeud de calcul est similaire au deuxième noeud, à ceci près qu'il comprend non pas un seul mais plusieurs (trois dans l'exemple représenté) modules mémoires METEOR du type décrit en relation avec la figure 1. Les modules mémoire METEOR sont reliés au circuit d'accélération matérielle par l'intermédiaire d'un bus local, désigné par la référence "Local Bus". Dans chacun des deuxième et troisième noeuds de calcul, le processeur est adapté à commander, par l'intermédiaire du circuit d'accélération matérielle du noeud, l'exécution d'opérations de calcul dans le ou les modules mémoire METEOR du noeud.

La figure 8 illustre un exemple d'implémentation des interfaces extérieures d'un module mémoire 100 (METEOR) du type décrit en relation avec la figure 1, correspondant aux ports d'entrée/sortie 123 et 131 de la figure 1. Ces interfaces peuvent correspondre aux interfaces d'un circuit mémoire standard et permettent de relier la mémoire à d'autres composants « maitres », par exemple via un bus, en tant que mémoire esclave. Dans l'exemple représenté, les interfaces extérieures du module mémoire 100 comprennent :
- des entrées d'adresses et de contrôle comprenant un port d'entrée d'adresses ADDR (32 bits dans l'exemple représenté), et trois ports d'entrée de contrôle BE (4 bits dans cet exemple), WE (1-bit dans cet exemple) et REQ (1 bit dans cet exemple) correspondant à des signaux classiques indiquant respectivement la taille des données masquées, l'opération de lecture/écriture souhaitée et de requête d'accès à la mémoire par un composant maître ;
- une entrée de données comprenant un port d'entrée de données WDATA (32 bits dans l'exemple représenté) ;
- des entrées de signaux de contrôle global comprenant un noeud d'application d'un signal de réinitialisation RESET_N et un noeud d'application d'un signal d'horloge CLK ;
- des sorties de contrôle comprenant trois nœuds de fourniture de signaux de contrôle RESP, READY et ERROR ; et
- une sortie de données comprenant un port de sorties de données RDATA (32 bits dans l'exemple représenté).

Le maitre peut fournir des informations d'adresses, de données et de contrôle pour initier des opérations de lecture et d'écriture. L'esclave peut fournir un statut du transfert au maître (signal RESP), un signal lorsque le transfert est terminé (READY) et un signal d'erreur (ERROR). Des instructions spécifiques à la mise en oeuvre d'opérations de calcul peuvent être encapsulées dans les signaux d'entrée ADDR et WDATA. Un exemple de circuit mémoire esclave pouvant décoder des instructions envoyées par un processeur est décrit dans la demande de brevet français 1762468.

La figure 9 illustre un exemple de format d'instruction pouvant être utilisé pour communiquer entre un circuit extérieur, par exemple un processeur, et un module mémoire du type décrit en relation avec la figure 1. Du point de vue de l'exécution, envoyer une instruction de calcul au module mémoire est équivalent à écrire une donnée spécifique à une adresse spécifique dans une mémoire virtuelle.

On a représenté sur la figure 9 trois types d'instructions :
- les instructions de type R (référencées "R-Type" sur la figure) dans lesquelles les opérandes du calcul à effectuer se situent dans deux rangées distinctes du module mémoire ;
- les instructions de type I (référencées "I-Type" sur la figure) qui s'appliquent entre une valeur opérande immédiate de 16 bits et une seule rangée de la mémoire ; et
- les instructions de type U (référencées "U-Type" sur la figure) qui contiennent une seule valeur opérande immédiate de 32 bits applicable à une rangée de la mémoire.

Dans cet exemple, chaque instruction requiert un total d'au moins 56 bits et est transmise en un cycle via les bus ADDR et WDATA. Chaque instruction contient, sur le bus ADDR, un champ "opcode" (incluant par exemple des champs de largeur "width", de catégorie "cat.", de type "typ." et d'opération "operation") définissant l'opération à effectuer, et un champ "@D (RDT)" contenant l'adresse de destination du résultat de l'opération. Dans les instructions de type R, chaque instruction contient en outre, sur le bus WDATA, un champ "@S1 (RS1)" contenant l'adresse du premier opérande R1 de l'opération, et un champ"@S2 (RS2)" contenant l'adresse du deuxième opérande R2 de l'opération. Dans les instructions de type I, chaque instruction contient, sur le bus WDATA, un champ "imm" de 16 bits contenant une valeur opérande immédiate de l'opération, et un champ "@S1 (RS1)" contenant l'adresse du deuxième opérande de l'opération. Dans les instructions de type U, chaque instruction contient, sur le bus WDATA, un champ "imm" de 32 bits contenant une valeur opérande immédiate.

La figure 10 détaille un exemple d'implémentation des interfaces du circuit de contrôle 120 (TAM) du module mémoire de la figure 1.

Dans cet exemple, le circuit 120 est connecté aux ports WDATA, ADDR, BE, WE, RDATA, RESET_N et CLK décrits ci-dessus.

Dans l'exemple représenté, le circuit 120 comprend un port d'entrée CSR_IN connecté au circuit de registres 140. A titre d'exemple, le port CSR_IN est un port de R*32 bits, où R désigne le nombre de registres de configuration du circuit 140.

Le circuit 120 comprend en outre un port d'entrée de contrôle NMC_CTRL (3 bits dans cet exemple) connecté au bus Control (figure 1) et adapté à recevoir du circuit de régulation 130 des signaux de contrôle des opérations de calcul à mettre en oeuvre dans le module mémoire, et un port d'entrée de contrôle VT_CTRL (4 bits dans cet exemple) adapté à recevoir du circuit de régulation 130 des signaux de contrôle de la configuration des circuits de transfert 113 du module mémoire.

Le circuit 120 de la figure 10 comprend en outre, connectés au bus TTC :
- K ports de sortie de contrôle TILE_NMC_CTRL_<i> (3 bits chacun dans cet exemple) destinés à fournir des signaux de contrôle des opérations de calcul à mettre en oeuvre respectivement dans les K rangées du module mémoire ; et
- K ports de sortie de contrôle TILE_VT_CTRL_<i> (4 bits chacun dans cet exemple) destinés à fournir des signaux de contrôle des circuits de transfert vertical 113 respectivement dans les K rangées du module mémoire.

Le circuit 120 de la figure 10 comprend de plus, connectés au bus TDI :
- un port de sortie de données TILE _WDATA (32 bits dans cet exemple) connecté au port d'entrée de données correspondant de chacun des blocs élémentaires 110 du module mémoire ;
- un port de sortie d'adresse TILE_ADDR connecté au port d'entrée d'adresse correspondant de chacun des blocs élémentaires 110 du module mémoire ;
- un port de sortie de contrôle TILE_BE (4 bits dans cet exemple) connecté à un port d'entrée de contrôle correspondant de chacun des blocs élémentaires 110 du module mémoire ;
- un port de sortie de contrôle TILE_WE (1 bit dans cet exemple) connecté à un port d'entrée de contrôle correspondant de chacun des blocs élémentaires 110 du module mémoire ;
- K*P ports de sortie d'activation TILE_EN<i,j> (1 bit chacun dans cet exemple) connectés respectivement à des ports d'entrée d'activation correspondants des K*P blocs élémentaires 110 du module mémoire ; et
- K*P ports d'entrée de données TILE_RDATA<i,j> (32 bit chacun dans cet exemple) connectés respectivement aux ports de sortie de données correspondants des K*P blocs élémentaires 110 du module mémoire.

Dans cet exemple, le circuit 120 peut opérer dans trois modes. Le premier mode est un mode de lecture standard. Le circuit 120 génère alors l'adresse cible (TILE_ADDR) et sélectionne le bloc 110 correspondant (TILE_EN) via le bus TDI. Au cycle suivant, la donnée lue est retournée (TILE_RDATA) via le bus TDI puis à travers un multiplexeur vers le port RDATA. Le second mode est un mode d'écriture standard. Ce mode est similaire au mode de lecture, à la différence près que la donnée à écrire est reçue via le port WDATA. Cette opération prend également un cycle d'horloge.

Le troisième mode est un envoi d'instruction de calcul vers les blocs élémentaires 110 du module mémoire. Lorsque l'instruction est reçue par le circuit 120, les adresses source et de destination absolues contenues dans les ports WDATA et ADDR sont retranscrites en adresses de vecteurs, et l'instruction est transmise à tous les blocs 110 contenant les éléments des vecteurs concernés par l'opération, via le bus TDI. Dans le même cycle, le circuit de régulation 130 détecte les éventuels conflits d'adresse et envoie les signaux de contrôle correspondants (NMC_CTRL, VT_CTRL) au circuit 120, qui les distribue via le bus TTC après adaptation, notamment pour tenir compte de l'adressage des blocs élémentaires concernés.

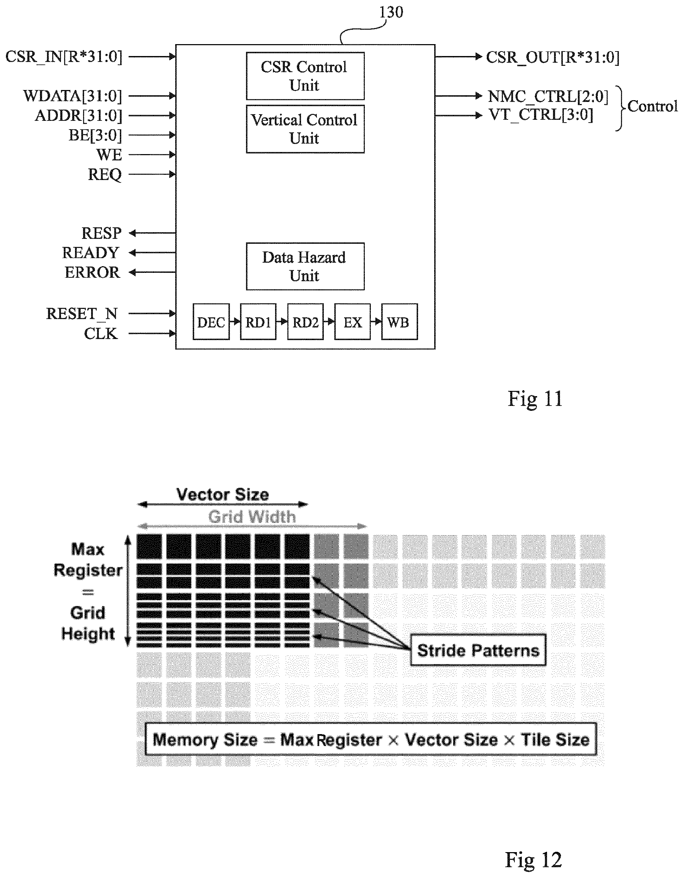

La figure 11 détaille un exemple d'implémentation du circuit de régulation 130 du module mémoire de la figure 1. Dans cet exemple, le circuit 130 comprend un circuit référencé "Data Hazard Unit" qui vérifie les éventuels conflits inter-instructions, un circuit référencé "Vertical Control Unit" qui vérifie les éventuels conflits de transfert vertical de données, et un circuit référencé "CSR Control Unit" qui gère les registres de configuration 140 pour la configuration globale de la matrice de blocs élémentaires 110. Le circuit 130 réplique le flux complet d'instructions pipelinées de la mémoire et met en attente le processeur maitre lorsque cela est nécessaire.

La figure 12 illustre un exemple de fonctionnement du circuit de registres de configuration 140 du module mémoire de la figure 1.

Pour reconfigurer la matrice de blocs élémentaires 110 du module mémoire, des paramètres du circuit 140 sont mis à jour. Ces paramètres peuvent être mis à jour ou lus pendant l'exécution d'un programme par un processeur relié au module 100 en utilisant par exemple une instruction spécifique du type décrit ci-dessus (figure 9, avec une instruction spécifique pouvant inclure un opcode spécifique). Cette instruction spécifique va permettre de configurer différents paramètres. Par exemple, comme l'illustre la figure 12, les paramètres "Grid Width" et "Grid Height" du circuit 140 définissent les dimensions d'un rectangle de blocs élémentaires 110 utilisés pour mettre en oeuvre des opérations de calcul. Le paramètre "Vector Size" permet de définir des vecteurs de dimensions inférieures ou égales à la largeur du rectangle, de façon à pouvoir, si besoin, économiser de l'énergie, au prix d'une diminution de la taille de la mémoire virtuellement disponible (paramètre "Memory Size"). Le paramètre "Stride Patterns" permet d'écrire ou de lire des vecteurs de données avec un entrelacement. Le paramètre "Max Register" définit le nombre maximum de registres interne IR disponibles dans les blocs élémentaires 110 et utilisables pour des opérations de calcul demandées au module mémoire. Le paramètre "Memory Size" est égal au produit des paramètres "Max Register", "Vector Size" et "Tile_Size" ("Memory Size" = "Max Register" x "Vector Size" x "Tile_Size"), avec Tile_Size représentant la taille de circuit mémoire.

On notera que dans les exemples décrits précédemment, on utilise une instruction spécifique pour définir les tailles de vecteurs utilisés. Alternativement, il est possible de spécifier la taille des vecteurs, ou plus généralement, l'agencement logique des blocs élémentaires 110 du module 100, dans chaque instruction envoyée. Pour cela, chaque instruction peut contenir un champ de configuration. Dans ce cas, le registre de configuration 140 peut être omis.

Néanmoins, pour faciliter la mise en œuvre du contrôle général par le bloc TAM 120, il est plus simple d'avoir une instruction dédiée, en outre cela évite d'augmenter le nombre de bits nécessaire pour encoder l'instruction.

De nombreuses applications de calcul peuvent tirer profit d'un module mémoire reconfigurable du type présenté en relation avec la figure 1. Des exemples d'applications vont être décrits ci-après. Les modes de réalisation décrits ne se limitent bien entendu pas à ces exemples.

Un premier exemple d'application pouvant tirer profit d'un module mémoire reconfigurable du type présenté en relation avec la figure 1 est une application de recherche d'un motif prédéfini dans une séquence de valeurs, par exemple une séquence d'ADN. Pour cela, on peut utiliser une méthode dite shift-or (décalage ou), par exemple telle que décrite dans l'article intitulé "The Exact Online String Matching Problem: a Review of the Most Recent Results", de Simone Faro et Thierry Lecroq. A titre d'exemple, un tronçon de la séquence d'ADN étudiée peut être chargé dans un premier vecteur horizontal de dimension N. Un jeu de M masques de dimension N correspondant au motif à rechercher est en outre chargé dans M autres vecteurs horizontaux de dimensions N alignés verticalement avec le premier vecteur. Une comparaison verticale de mot à mot est mise en oeuvre entre le premier vecteur et chacun des masques. L'algorithme est ensuite répété pour chacun des tronçons suivants de la séquence d'ADN. Plus la dimension des vecteurs horizontaux est importante, plus la recherche sera rapide. Une configuration telle que la configuration (C) de la figure 3 pourra par exemple être privilégiée pour cette application.

Un deuxième exemple d'application pouvant tirer profit d'un module mémoire du type présenté en relation avec la figure 1 est la mise en oeuvre d'un algorithme de type noyau entièrement connecté (en anglais "fully connected kernel"). Ce type d'algorithme peut notamment être utilisé dans les couches finales d'un algorithme de classification à base de réseaux neuronaux. Une quantité de mémoire relativement faible peut être utilisée pour stocker les données d'entrée, et une quantité de mémoire relativement élevée peut être utilisée pour stocker les données de poids ou données de pondération. Les données d'entrée peuvent par exemple être chargées dans un premier vecteur horizontal, et les coefficients de pondération peuvent être chargés dans une pluralité de vecteurs horizontaux alignés verticalement avec le vecteur contenant les données d'entrée. Ainsi, les données d'entrée peuvent être multipliées par un grand nombre de coefficients de pondération. L'algorithme peut en outre calculer la somme de chaque vecteur résultant de la multiplication du vecteur de données d'entrée par un vecteur de poids (sommation pondérée). Lors du calcul, les données d'entrée peuvent être déplacées verticalement vers chaque vecteur de poids, par l'intermédiaire des circuits de transfert vertical 113, pour réaliser les opérations de multiplications dans les blocs élémentaires 110 stockant les vecteurs de poids. Ceci permet d'éviter d'avoir à répliquer les données d'entrée dans chaque rangée de blocs élémentaires 110 du module mémoire, réduisant ainsi la quantité totale de mémoire nécessaire à l'exécution de l'algorithme.

Un troisième exemple d'application pouvant tirer profit d'un module mémoire du type présenté en relation avec la figure 1 est la mise en oeuvre d'un algorithme utilisant des données entrelacées partagées, par exemple un noyau de convolution utilisé dans les couches principales d'un réseau neuronal convolutif, utilisant une relativement grande quantité de mémoire pour stocker les données d'entrée et une relativement petite quantité de mémoire pour stocker les données de poids. Les données de poids peuvent par exemple être stockées dans certaines des rangées de blocs élémentaires 110 du module mémoire, et les données d'entrée distribuées dans l'ensemble des blocs élémentaires 110. Les transferts verticaux, via les circuits de transfert 113, permettent de déplacer vers le haut ou vers le bas les données de poids dans les blocs contenant les données d'entrée, pour effectuer les calculs. Ainsi, les données de poids peuvent être partagées par les différentes rangées de blocs élémentaires, réduisant la quantité totale de mémoire nécessaire à l'exécution de l'algorithme.

Un quatrième exemple d'application pouvant tirer profit d'un module mémoire du type présenté en relation avec la figure 1 est la mise en oeuvre d'opérations de réduction. De telles opérations sont utilisées par exemple dans des algorithmes de type BLAS (de l'anglais "Basic Linear Algebra Subprograms" - sous-programmes d'algèbre linéaire basique), mettant en oeuvre une même opération entre tous les éléments composant un vecteur. Lorsque les vecteurs sont de grandes dimensions, la mise en oeuvre d'une telle opération avec un processeur scalaire est proportionnelle à la taille des vecteurs. La reconfigurabilité du module mémoire permet d'augmenter la taille des vecteurs horizontaux disponibles pour effectuer des calculs, et ainsi de réduire significativement le nombre de cycles requis pour mettre en oeuvre de telles opérations.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de valeurs numériques mentionnés dans la présente description.

En outre, l'homme de l'art pourra se référer aux documents listés ci-après pour obtenir une plus ample description des notions et acronymes utilisés dans la présente description.

### Références :

[1] Multi-layer AHB Technical Overview v2.0, 2006. URL: https://developer.arm.com/docs/dvi0045/b/multi-layer-ahb-technical-overview-v20.
[2] AMBA 3 AHB-Lite Protocol Specification v1.0, March 2010. URL: https://developer.arm.com/docs/ihi0033/a/amba-3-ahb-lite-protocol-specification-v10.
[3] A. Agrawal, A. Jaiswal, C. Lee, and K. Roy. X-SRAM: Enabling in-memory boolean computations in CMOS static random access memories. IEEE Transactions on Circuits and Systems I: Regular Papers, 2018. doi:10.1109/TCSI.2018.2848999.
[4] K. C. Akyel, H.-P. Charles, J. Mottin, B. Giraud, G. Suraci, S. Thuries, and J.-P. Noel. DRC2: Dynamically Reconfigurable Computing Circuit based on memory architecture. In IEEE International Conference on Rebooting Computing (ICRC), 2016. doi:10.1109/ICRC.2016.7738698.
[5] C. Eckert, X. Wang, J. Wang, A. Subramaniyan, R. Iyer, D. Sylvester, D. Blaaauw, and R. Das. Neural Cache: Bit-Serial In-Cache Acceleration of Deep Neural Networks. In ACM/IEEE International Symposium on Computer Architecture (ISCA), 2018. doi:10.1109/ISCA.2018.00040.
[6] S. Faro and T. Lecroq. The exact online string matching problem: a review of the most recent results. ACM Computing Surveys (CSUR), 2013. doi:10.1145/2431211.2431212.
[7] R. Gauchi, M. Kooli, P. Vivet, J.-P. Noel, E. Beigné, S. Mitra, and H.-P. Charles. Memory sizing of a scalable sram in-memory computing tile based architecture. In IFIP/IEEE International Conference on Very Large Scale Integration and System-on-Chip designs (VLSI-SoC), 2019. doi:10.1109/VLSI-SoC.2019.8920373.
[8] J. Wang, X. Wang, C. Eckert, A. Subramaniyan, R. Das, D. Blaauw, and D. Sylvester. A Compute SRAM with Bit-Serial Integer/Floating-Point Operations for Programmable In-Memory Vector Acceleration. In IEEE International Solid-State Circuits Conference (ISSCC), 2019. doi:10.1109/ISSCC.2019.8662419.
[9] M. Kooli, H. Charles, C. Touzet, B. Giraud, and J. Noel. Smart instruction codes for in-memory computing architectures compatible with standard SRAM interfaces. In Design, Automation & Test in Europe Conference & Exhibition (DATE), 2018. doi:10.23919/DATE.2018.8342276.
[10] J.-P. Noel, V. Eglo_, M. Kooli, R. Gauchi, J.-M. Portal, H.-P. Charles, P. Vivet, and B. Giraud. Computational SRAM Design Automation using Pushed-Rule Bitcells for Energy-Efficient Vector Processing. In Design, Automation & Test in Europe Conference & Exhibition (DATE), 2020.
[11] W. A. Simon, Y. M. Qureshi, A. Levisse, M. Zapater, and D. Atienza. BLADE: A BitLine Accelerator for Devices on the Edge. Proceedings of the ACM Great Lakes Symposium on VLSI (GLSVLSI), 2019. doi:10.1145/3299874.3317979.
[12] G. Singh, L. Chelini, S. Corda, A. Javed Awan, S. Stuijk, R. Jordans, H. Corporaal, and A. Boonstra. A Review of Near-Memory Computing Architectures: Opportunities and Challenges. In Euromicro Conference on Digital System Design (DSD), 2018. doi:10.1109/DSD.2018.00106.
[13] N. Stephens, S. Biles, M. Boettcher, J. Eapen, M. Eyole, G. Gabrielli, M. Horsnell, G. Magklis, A. Martinez, N. Premillieu, A. Reid, A. Rico, and P. Walker. The ARM Scalable Vector Extension. IEEE Micro, 2017. doi:10.1109/MM.2017.35.
[14] A. Traber, M. Gautschi, and P.D. Schiavone. RI5CY: User Manual, 2019. URL: https://www.pulp-platform.org/docs/ri5cy_user_manual.pdf.

Enfin, la mise en oeuvre pratique des modes de réalisation et variantes décrits est à la portée de la personne du métier à partir des indications fonctionnelles données ci-dessus. En particulier, la réalisation des différents éléments fonctionnels du module mémoire de la figure 1 sont à la portée de la personne du métier à partir des indications de la présente description.

## Revendications

1. Module mémoire (100) adapté à mettre en oeuvre des opérations de calcul, le module comportant une pluralité de blocs élémentaires (110) agencés en matrice selon des rangées et des colonnes, dans lequel :
chaque bloc élémentaire (110) comporte un circuit mémoire (111) adapté à mettre en oeuvre des opérations de calcul, et un circuit de transfert configurable (113), le circuit mémoire (111) comprenant une matrice (501) de cellules élémentaires de stockage, des circuits adaptés à mettre en oeuvre des calculs au sein ou en périphérie de la matrice de cellules élémentaires de stockage, et un circuit de contrôle (FSM) adapté à décoder et à commander l'exécution, au sein du circuit mémoire (111), d'instructions de lecture, d'écriture et/ou de calcul reçues via un bus de distribution (TDI) ;
dans chaque colonne de la matrice, les circuits de transfert configurables (113) des blocs élémentaires (110) de la colonne sont reliés par au moins un bus de liaison (VTI-U, VTI-D) ;
chaque circuit de transfert configurable (113) est paramétrable pour transmettre des données issues d'un premier bloc élémentaire émetteur vers un bloc élémentaire récepteur d'une même colonne de blocs élémentaires via ledit au moins un bus de liaison ;
un circuit interne de contrôle (120) est connecté à un port d'entrée-sortie (123) du module comprenant un port d'entrée de données (WDATA), un port de sortie de données (RDATA) et un port d'entrée d'adresses (ADDR), le port d'entrée-sortie du module (123) étant destiné à être connecté à un dispositif extérieur ; et
le circuit interne de contrôle (120) est configuré pour lire au moins un signal d'instruction sur le port d'entrée-sortie (123) du module et paramétrer en conséquence la configuration des circuits de transfert configurables (113), au moins un signal d'instruction permettant de définir la taille des vecteurs opérandes des opérations de calcul mises en oeuvre par le module mémoire, dans lequel au moins un signal d'instruction pouvant être reçu sur le port d'entrée-sortie du module mémoire (100) code une opération à réaliser entre deux opérandes stockés dans des circuits mémoire (111) différents appartenant respectivement à au moins un premier bloc élémentaire (110) et au moins un deuxième bloc élémentaire (110), et pour laquelle l'exécution de l'opération comprend une opération de transfert d'un des opérandes dudit au moins un premier bloc élémentaire vers ledit au moins un deuxième bloc élémentaire par l'intermédiaire des circuits de transfert configurables (113) desdits au moins un premier et au moins un deuxième blocs élémentaires et dudit au moins un bus de liaison (VTI-U, VTI-D),
le module mémoire comprenant en outre un registre de configuration (CSR) mémorisant une information sur la taille courante des vecteurs opérandes, le registre de configuration étant mis à jour après réception d'un signal d'instruction de configuration de taille provenant dudit dispositif extérieur,
le module mémoire comprenant une pluralité de blocs élémentaires (110) agencés en matrice selon K rangées et P colonnes, avec P entier supérieur ou égal à 1, et K entier supérieur à 1, et la taille des vecteurs opérandes pouvant prendre plusieurs valeurs différentes dont au moins une première taille inférieure à une deuxième taille, et, lorsque la première taille est appliquée, un opérande est stocké dans les circuits mémoire d'une unique rangée de blocs élémentaires (110) et, lorsque la deuxième taille est appliquée, un opérande est stocké dans les circuits mémoire de plusieurs rangées de blocs élémentaires, chaque circuit mémoire comprenant une partie de l'opérande de deuxième taille, une unique taille de vecteur étant appliquée à un moment donné et définie par le registre de configuration.

2. Module mémoire selon la revendication 1, dans lequel, lorsque la deuxième taille est appliquée, un premier opérande est stocké dans plusieurs premiers blocs élémentaires appartenant à des rangées différentes et un deuxième opérande est stocké dans plusieurs deuxièmes blocs élémentaires appartenant à des rangées différentes, et dans lequel l'opération de transfert du premier opérande comprend plusieurs opérations de transfert indépendantes d'un premier bloc élémentaire vers un deuxième bloc élémentaire.

3. Module mémoire selon la revendication 1, dans lequel lorsque la deuxième taille est appliquée, la matrice de blocs élémentaires est organisée en plusieurs groupes de rangées, chaque groupe de rangées étant utilisé pour stocker une même portion d'un opérande donné, et dans lequel les transferts de données entre deux blocs élémentaires d'une même colonne sont possibles uniquement au sein d'un même groupe de rangées.

4. Module mémoire selon la revendication 1, dans lequel :
dans chaque colonne de la matrice, les circuits de transfert configurables (113) des blocs élémentaires (110) de la colonne sont reliés par des bus de liaison montants (VTI-U) et descendants (VTI-D) ;
chaque circuit de transfert configurable (113) est commandable pour transmettre des données entre deux bus de liaison montants, entre deux bus de liaison descendants, et/ou entre le circuit mémoire (111) du bloc élémentaire correspondant et les deux bus de liaison montants et/ou les deux bus de liaison descendants.

5. Module mémoire (100) selon la revendication 4, dans lequel :
dans chaque colonne de la matrice, les circuits de transfert configurables (113) de deux blocs élémentaires (110) adjacents quelconques de la colonne sont reliés deux à deux par un bus de liaison montant (VTI-U) et par un bus de liaison descendant (VTI-D) ;
dans chaque bloc élémentaire (110) de chaque colonne de la matrice, à l'exception des blocs élémentaires (110) des première et dernière rangées de la matrice, le circuit de transfert configurable (113) du bloc élémentaire (110) est commandable pour :
a) transmettre sur un premier port d'entrée de données (VT_WDATA) du circuit mémoire (111) du bloc élémentaire (110) l'un ou l'autre de :
- un mot de données reçu sur le bus de liaison descendant (VTI-D) reliant le bloc élémentaire (110) au bloc élémentaire (110) adjacent de rang inférieur dans la colonne ; et
- un mot de données reçu sur le bus de liaison montant (VTI-U) reliant le bloc élémentaire (110) au bloc élémentaire (110) adjacent de rang supérieur dans la colonne ;
b) transmettre sur le bus de liaison montant (VTI-U) reliant le bloc élémentaire (110) au bloc élémentaire (110) adjacent de rang inférieur dans la colonne l'un ou l'autre de :
- un mot de données reçu sur un premier port de sortie de données (VT _RDATA) du circuit mémoire (111) du bloc élémentaire (110) ; et
- un mot de données reçu sur le bus de liaison montant (VTI-U) reliant le bloc élémentaire (110) au bloc élémentaire (110) adjacent de rang supérieur dans la colonne ; et
c) transmettre sur le bus de liaison descendant (VTI-D) reliant le bloc élémentaire (110) au bloc élémentaire (110) adjacent de rang supérieur dans la colonne l'un ou l'autre de :
- un mot de données reçu sur le premier port de sortie de données (VT _RDATA) du circuit mémoire (111) du bloc élémentaire (110) ; et
- un mot de données reçu sur le bus de liaison descendant (VTI-D) reliant le bloc élémentaire (110) au bloc élémentaire (110) adjacent de rang inférieur dans la colonne.

6. Module mémoire (100) selon la revendication 1, dans lequel les circuits de transfert (113) des différents blocs élémentaires (110) de la matrice sont connectés au circuit interne de contrôle (120) du module mémoire par l'intermédiaire d'un bus de contrôle (TTC).

7. Module mémoire (100) selon l'une quelconque des revendications 1 à 6, dans lequel les circuits mémoire (111) des différents blocs élémentaires (110) de la matrice sont connectés au circuit interne de contrôle (120) par l'intermédiaire d'un bus de distribution (TDI).

8. Module mémoire (100) selon la revendication 7, dans lequel chaque circuit mémoire (111) comprend un deuxième port d'entrée de données (TILE _WDATA) et un deuxième port de sortie de données (TILE _RDATA) connectés au bus de distribution (TDI).

9. Module mémoire (100) selon la revendication 8, dans lequel la largeur du deuxième port d'entrée de données (TILE _WDATA) et la largeur du deuxième port de sortie de données (TILE _RDATA) sont inférieures ou égales respectivement à la largeur du premier port d'entrée de données (VT _WDATA) et à la largeur du premier port de sortie de données (VT_RDATA).

10. Module mémoire (100) selon la revendication 9, dans lequel la largeur du deuxième port d'entrée de données (TILE _WDATA) et la largeur du deuxième port de sortie de données (TILE _RDATA) sont strictement inférieures respectivement à la largeur du premier port d'entrée de données (VT _WDATA) et à la largeur du premier port de sortie de données (VT_RDATA).

11. Module mémoire (100) selon l'une quelconque des revendications 7 à 10, dans lequel chaque circuit mémoire (111) comprend en outre un port d'entrée d'adresses connecté au bus de distribution (TDI).

12. Module mémoire (100) selon l'une quelconque des revendications 1 à 11, comprenant en outre un circuit (130) de régulation globale des accès, connecté au circuit interne de contrôle (120), le circuit de régulation globale des accès réalisant un suivi des instructions reçues sur le port d'entrée-sortie du module et demandant si nécessaire au circuit interne de contrôle (120) d'attendre avant de requérir l'exécution d'une instruction par un bloc élémentaire ou avant de réaliser un transfert de données entre plusieurs blocs élémentaires via ledit au moins un bus de liaison.

13. Module mémoire (100) selon l'une quelconque des revendications 5 à 12, dans lequel, dans chaque bloc élémentaire (110), le circuit de transfert (113) du bloc comprend des premier (M1), deuxième (M2) et troisième (M3) multiplexeurs ayant chacun des premier et deuxième ports d'entrée et un port de sortie et dans lequel :
- le premier multiplexeur (M1) a ses premier et deuxième ports d'entrée connectés respectivement au bus de liaison descendant (VTI-D) reliant le bloc élémentaire (110) au bloc élémentaire (110) adjacent de rang inférieur dans la colonne et au bus de liaison montant (VTI-U) reliant le bloc élémentaire (110) au bloc élémentaire (110) adjacent de rang supérieur dans la colonne, et son port de sortie connecté au premier port d'entrée de données (VT_WDATA) du circuit mémoire (111) du bloc élémentaire (110) ;
- le deuxième multiplexeur (M2) a ses premier et deuxièmes ports d'entrée connectés respectivement au premier port de sortie de données (VT_RDATA) du circuit mémoire (111) du bloc élémentaire (110) et au bus de liaison montant (VTI-U) reliant le bloc élémentaire (110) au bloc élémentaire (110) adjacent de rang supérieur dans la colonne, et son port de sortie connecté au bus de liaison montant (VTI-U) reliant le bloc élémentaire (110) au bloc élémentaire (110) adjacent de rang inférieur dans la colonne ; et
- le troisième multiplexeur (M2) a ses premier et deuxième ports d'entrée connectés respectivement au premier port de sortie de données (VT_RDATA) du circuit mémoire (111) du bloc élémentaire (110) et au bus de liaison descendant (VTI-D) reliant le bloc élémentaire (110) au bloc élémentaire (110) adjacent de rang inférieur dans la colonne, et son port de sortie connecté au bus de liaison descendant (VTI-D) reliant le bloc élémentaire (110) au bloc élémentaire (110) adjacent de rang supérieur dans la colonne.

14. Module mémoire (100) selon l'une quelconque des revendications 1 à 13, dans lequel ladite instruction est transmise via le port d'entrée de données (WDATA) et le port d'entrée d'adresses (ADDR) du port d'entrée-sortie (123) du module mémoire.

15. Module mémoire (100) selon l'une quelconque des revendications 1 à 14, le module mémoire étant en outre adapté à mettre en oeuvre des opérations de calcul entre deux autres opérandes stockés dans un même circuit mémoire (111) d'un bloc élémentaire (110).

16. Système comprenant un module mémoire (100) selon l'une quelconque des revendications 1 à 15, et une unité de traitement reliée au module mémoire par l'intermédiaire du port d'entrée-sortie (123) du module mémoire, le module mémoire étant relié à un bus et se comportant comme un composant esclave sur ledit bus.

## Patentansprüche

1. Speichermodul (100), das zur Durchführung von Rechenoperationen angepasst ist, wobei das Modul eine Vielzahl von Elementarblöcken (110) aufweist, die in einem Array gemäß Zeilen und Spalten angeordnet sind, wobei:
jeder Elementarblock (110) eine Speicherschaltung (111), die zur Durchführung von Rechenoperationen angepasst ist, und eine konfigurierbare Übertragungsschaltung (113) aufweist, wobei die Speicherschaltung (111) ein Array (501) von elementaren Speicherzellen, Schaltungen, die zur Durchführung von Rechenoperationen innerhalb oder am Rand des Arrays von elementaren Speicherzellen angepasst sind, und eine Steuerschaltung (FSM) aufweist, die zur Dekodierung und Steuerung einer Ausführung von Lese-, Schreib- und/oder Rechenanweisungen, die über einen Verteilerbus (TFI) empfangen werden, innerhalb der Speicherschaltung (111) angepasst ist;
in jeder Spalte des Arrays die konfigurierbaren Übertragungsschaltungen (113) der Elementarblöcke (110) in der Spalte durch mindestens einen Verbindungsbus (VTI-U, VTI-D) gekoppelt sind;
jede konfigurierbare Übertragungsschaltung (113) parametrisierbar ist, um Daten, die von einem ersten Sende-Elementarblock stammen, über den mindestens einen Verbindungsbus an einen Empfangs-Elementarblock derselben Spalte von Elementarblöcken zu übertragen;
eine interne Steuerschaltung (120) mit einem Ein-/Ausgabe-Port (123) des Moduls verbunden ist, der einen Dateneingabe-Port (WDATA), einen Datenausgabe-Port (RDATA) und einen Adresseingabe-Port (ADDR) aufweist, wobei der Ein-/Ausgabe-Port (123) des Moduls dazu bestimmt ist, mit einer externen Vorrichtung verbunden zu werden; und der interne Steuerkreis (120) so konfiguriert ist, dass er mindestens ein Befehlssignal am Ein-/Ausgabe-Port (123) des Moduls liest und dementsprechend die Konfiguration der konfigurierbaren Übertragungsschaltungen (113) parametrisiert, wobei mindestens ein Befehlssignal eine Definition der Größe der Operandenvektoren der durch das Speichermodul implementierten Rechenoperationen ermöglicht,
wobei mindestens ein Befehlssignal, das am Ein-/Ausgabe-Port des Speichermoduls (100) empfangen werden kann, eine Operation codiert, die zwischen zwei Operanden ausgeführt werden soll, die in verschiedenen Speicherschaltungen (111) gespeichert sind, die jeweils zu mindestens einem ersten Elementarblock (110) und mindestens einem zweiten Elementarblock (110) gehören, und für die die Ausführung der Operation eine Übertragungsoperation von einem der Operanden von dem mindestens einen ersten Elementarblock zu dem mindestens einen zweiten Elementarblock über die konfigurierbaren Übertragungsschaltungen (113) des mindestens einen ersten und des mindestens einen zweiten Elementarblocks und des mindestens einen Verbindungsbus (VTI-U, VTI-D) aufweist,
wobei das Speichermodul ferner ein Konfigurationsregister (CSR) aufweist, das Informationen bezüglich der aktuellen Größe der Operandenvektoren speichert, wobei das Konfigurationsregister nach Empfang eines Größenkonfigurationsbefehlssignals, das von der externen Vorrichtung stammt, aktualisiert wird,
wobei das Speichermodul eine Vielzahl von Elementarblöcken (110) aufweist, die in einem Array gemäß K Zeilen und P Spalten angeordnet sind, wobei P eine ganze Zahl größer oder gleich 1 ist und K eine ganze Zahl größer als 1 ist, und wobei die Größe der Operandenvektoren eine Vielzahl von unterschiedlichen Werten annehmen kann, einschließlich mindestens einer ersten Größe, die kleiner als eine zweite Größe ist, und wobei bei Anwendung der ersten Größe ein Operand in den Speicherschaltungen einer einzelnen Reihe von Elementarblöcken (110) gespeichert wird und wobei bei Anwendung der zweiten Größe ein Operand in den Speicherschaltungen einer Vielzahl von Reihen von Elementarblöcken gespeichert wird, wobei jede Speicherschaltung einen Teil des Operanden der zweiten Größe aufweist und wobei eine einzelne Vektorgröße zu einem gegebenen Zeitpunkt angewendet und durch das Konfigurationsregister definiert wird.

2. Speichermodul gemäß Anspruch 1, wobei, wenn die zweite Größe angewendet wird, ein erster Operand in einer Vielzahl von ersten Elementarblöcken gespeichert wird, die zu verschiedenen Zeilen gehören, und wobei ein zweiter Operand in einer Vielzahl von zweiten Elementarblöcken gespeichert wird, die zu verschiedenen Zeilen gehören, und wobei die Übertragungsoperation des ersten Operanden eine Vielzahl von unabhängigen Übertragungsoperationen von einem ersten Elementarblock zu einem zweiten Elementarblock aufweist.

3. Speichermodul gemäß Anspruch 1, wobei, wenn die zweite Größe angewendet wird, das Array von Elementarblöcken in einer Vielzahl von Gruppen von Zeilen organisiert ist, wobei jede Gruppe von Zeilen verwendet wird, um einen selben Teil eines gegebenen Operanden zu speichern, und wobei Datenübertragungen zwischen zwei Elementarblöcken einer selben Spalte nur innerhalb einer selben Gruppe von Zeilen möglich sind.

4. Speichermodul gemäß Anspruch 1, wobei:
in jeder Spalte des Arrays die konfigurierbaren Übertragungsschaltungen (113) der Elementarblöcke (110) in der Spalte durch Uplink- (VTI-U) und Downlink- (VTI-D) Busse gekoppelt sind;
jede konfigurierbare Übertragungsschaltung (113) steuerbar ist, um Daten zwischen zwei Uplink-Bussen, zwischen zwei Downlink-Bussen und/oder zwischen dem Speicherschaltkreis (111) des entsprechenden Elementarblocks und den zwei Uplink-Bussen und/oder den zwei Downlink-Bussen zu übertragen.

5. Speichermodul (100) gemäß Anspruch 4, wobei:
in jeder Spalte des Arrays die konfigurierbaren Übertragungsschaltungen (113) von zwei beliebigen benachbarten Elementarblöcken (110) der Spalte paarweise durch einen Uplink-Bus (VTI-U) und durch einen Downlink-Bus (VTI-D) gekoppelt sind;
in jedem Elementarblock (110) jeder Spalte des Arrays, mit Ausnahme der Elementarblöcke (110) der ersten und letzten Reihe des Arrays, die konfigurierbare Übertragungsschaltung (113) des Elementarblocks (110) steuerbar ist, zum:
a) Übertragen, an einem ersten Dateneingabe-Port (VT_WDATA) der Speicherschaltung (111) des Elementarblocks (110), von einem oder dem anderen der Folgenden:
- eines Datenworts, das über den Downlink-Bus (VTI-D) empfangen wird, der den Elementarblock (110) mit dem benachbarten Elementarblock (110) mit niedrigerem Rang in der Spalte koppelt; und
- eines Datenwortes, das über den Uplink-Bus (VTI-U) empfangen wird, das den Elementarblock (110) mit dem benachbarten Elementarblock (110) mit höherem Rang in der Spalte koppelt;
b) Übertragen, über den Uplink-Bus (VTI-U), der den Elementarblock (110) mit dem benachbarten Elementarblock (110) mit niedrigerem Rang in der Spalte koppelt, von einem oder dem anderen der Folgenden;
- eines Datenwortes, das an einem ersten Datenausgabe-Port (VT_RDATA) der Speicherschaltung (111) des Elementarblocks (110) empfangenen wird; und
- eines Datenwortes, das über den Downlink-Bus (VTI-U) empfangen wird, der den Elementarblock (110) mit dem benachbarten Elementarblock (110) mit höherem Rang in der Spalte koppelt; und
c) Übertragen, über den Downlink-Bus (VTI-D), der den Elementarblock (110) mit dem benachbarten Elementarblock (110) mit höherem Rang in der Spalte koppelt, von einem oder dem anderen der Folgenden:
- eines Datenwortes, das am ersten Datenausgabe-Port (VT_RDATA) der Speicherschaltung (111) des Elementarblocks (110) empfangen wird; und
- eines Datenwortes, das über den Downlink-Bus (VTI-D) empfangen wird, der den Elementarblock (110) mit dem benachbarten Elementarblock (110) mit niedrigerem Rang in der Spalte koppelt.

6. Speichermodul (100) gemäß Anspruch 1, wobei die Übertragungsschaltungen (113) der verschiedenen Elementarblöcke (110) des Arrays mit der internen Steuerschaltung (120) des Speichermoduls über einen Steuerbus (TTC) verbunden sind.

7. Speichermodul (100) gemäß einem der Ansprüche 1 bis 6, wobei die Speicherschaltungen (111) der verschiedenen Elementarblöcke (110) des Arrays über einen Verteilerbus (TDI) mit der internen Steuerschaltung (120) verbunden sind.

8. Speichermodul (100) gemäß Anspruch 7, wobei jede Speicherschaltung (111) einen zweiten Dateneingabe-Port (TILE_WDATA) und einen zweiten Datenausgabe-Port (TILE_RDATA) aufweist, die mit dem Verteilerbus (TDI) verbunden sind.

9. Speichermodul (100) gemäß Anspruch 8, wobei die Breite des zweiten Dateneingabe-Ports (TILE_WDATA) und die Breite des zweiten Datenausgabe-Ports (TILE_RDATA) jeweils kleiner oder gleich der Breite des ersten Dateneingabe-Ports (VT_WDATA) und der Breite des ersten Datenausgabe-Ports (VT_RDATA) sind.

10. Speichermodul (100) gemäß Anspruch 9, wobei die Breite des zweiten Dateneingabe-Ports (TILE_WDATA) und die Breite des zweiten Datenausgabe-Ports (TILE_RDATA) jeweils kleiner als die Breite des ersten Dateneingabe-Ports (VT_WDATA) und als die Breite des ersten Datenausgabe-Ports (VT_RDATA) sind.

11. Speichermodul (100) gemäß einem der Ansprüche 7 bis 10, wobei jede Speicherschaltung (111) ferner einen Adresseingabe-Port aufweist, der mit dem Verteilerbus (TDI) verbunden ist.

12. Speichermodul (100) gemäß einem der Ansprüche 1 bis 11, das ferner eine allgemeine Zugriffsregelungsschaltung (130) aufweist, die mit der internen Steuerschaltung (120) verbunden ist, wobei die allgemeine Zugriffsregelungsschaltung ein Tracking der an dem Ein-/Ausgabe-Port des Moduls empfangenen Anweisungen durchführt und erforderlichenfalls die interne Steuerschaltung (120) auffordert, zu warten, bevor die Ausführung einer Anweisung durch einen Elementarblock angefordert wird oder bevor eine Datenübertragung zwischen einer Vielzahl von Elementarblöcken über den mindestens einen Verbindungsbus durchgeführt wird.

13. Speichermodul (100) gemäß einem der Ansprüche 5 bis 12, wobei, in jedem Elementarblock (110), die Übertragungsschaltung (113) des Blocks einen ersten (M1), einen zweiten (M2) und einen dritten (M3) Multiplexer aufweist, die jeweils einen ersten und einen zweiten Eingabe-Port und einen Ausgabe-Port aufweisen, und wobei:
- der erste Multiplexer (M1) mit seinem ersten und zweiten Eingabe-Port jeweils mit dem Downlink-Bus (VTI-D) verbunden ist, der den Elementarblock (110) mit dem benachbarten Elementarblock (110) mit niedrigerem Rang in der Spalte koppelt, und mit dem Uplink-Bus (VTI-U) verbunden ist, der den Elementarblock (110) mit dem benachbarten Elementarblock (110) mit höherem Rang in der Spalte koppelt, und wobei dessen Ausgabe-Port mit dem ersten Dateneingabe-Port (VT_WDATA) der Speicherschaltung (111) des Elementarblocks (110) verbunden ist;
- der zweite Multiplexer (M2) mit seinem ersten und zweiten Eingabe-Port jeweils mit dem ersten Datenausgabe-Port (VT_RDATA) der Speicherschaltung (111) des Elementarblocks (110) und mit dem Uplink-Bus (VTI-U) verbunden ist, der den Elementarblock (110) mit dem benachbarten Elementarblock (110) mit höherem Rang in der Spalte koppelt, und wobei dessen Ausgabe-Port mit dem Uplink-Bus (VTI-U) verbunden ist, der den Elementarblock (110) mit dem benachbarten Elementarblock (110) mit niedrigerem Rang in der Spalte koppelt; und
- der dritte Multiplexer (M2) mit seinem ersten und zweiten Eingabe-Port jeweils mit dem ersten Datenausgabe-Port (VT_RDATA) der Speicherschaltung (111) des Elementarblocks (110) und mit dem Downlink-Bus (VTI-D) verbunden ist, der den Elementarblock (110) mit dem benachbarten Elementarblock (110) mit niedrigerem Rang in der Spalte koppelt, und wobei dessen Ausgabe-Port mit dem Downlink-Bus (VTI-D) verbunden ist, der den Elementarblock (110) mit dem benachbarten Elementarblock (110) mit höherem Rang in der Spalte koppelt.

14. Speichermodul (100) gemäß einem der Ansprüche 1 bis 13, wobei die Anweisung über den Dateneingabe-Port (WDATA) und den Adresseingabe-Port (ADDR) des Ein-/Ausgabe-Ports (123) des Speichermoduls übertragen wird.

15. Speichermodul (100) gemäß einem der Ansprüche 1 bis 14, wobei das Speichermodul ferner zum Durchführen von Rechenoperationen zwischen zwei anderen Operanden, die in derselben Speicherschaltung (111) eines Elementarblocks (110) gespeichert sind, angepasst ist.

16. System, das ein Speichermodul (100) gemäß einem der Ansprüche 1 bis 15 und eine Verarbeitungseinheit aufweist, die über den Ein-/Ausgabe-Port (123) des Speichermoduls mit dem Speichermodul gekoppelt ist, wobei das Speichermodul mit einem Bus gekoppelt ist und sich über den Bus als Slave-Komponente verhält.

## Claims

1. Memory module (100) adapted to implementing computing operations, the module comprising a plurality of elementary blocks (110) arranged in an array according to rows and columns, wherein:
each elementary block (110) comprises a memory circuit (111) adapted to implementing computing operations, and a configurable transfer circuit (113), the memory circuit (111) comprising an array (501) of elementary storage cells, circuits adapted to implementing computing operations within or at the periphery of the array of elementary storage cells, and a control circuit (FSM) adapted to decode and control execution, inside the memory circuit (111), of read, write and/or calculation instructions received via a distribution bus (TFI);
in each column of the array, the configurable transfer circuits (113) of the elementary blocks (110) in the column are coupled by at least one link bus (VTI-U, VTI-D);
each configurable transfer circuit (113) is parameterizable to transmit data originating from a first transmit elementary block to a receive elementary block of a same column of elementary blocks via said at least one link bus;
an internal control circuit (120) is connected to an input-output port (123) of the module comprising a data input port (WDATA), a data output port (RDATA), and an address input port (ADDR), the input-output port of the module (123) being intended to be connected to an external device; and
the internal control circuit (120) is configured to read at least one instruction signal on the input-output port (123) of the module and accordingly parameterize the configuration of the configurable transfer circuits (113), at least one instruction signal enabling to define the size of the operand vectors of the computing operations implemented by the memory module,
wherein at least one instruction signal capable of being received on the input-output port of the memory module (100) codes an operation to be performed between two operands stored in different memory circuits (111) respectively belonging to at least one first elementary block (110) and at least one second elementary block (110), and for which the execution of the operation comprises an operation of transfer of one of the operands from said at least one first elementary block to said at least one second elementary block via the configurable transfer circuits (113) of said at least one first and at least one second elementary blocks and said at least one link bus (VTI-U, VTI-D),
the memory module further comprising a configuration register (CSR) storing information relative to the current size of the operand vectors, the configuration register being updated after reception of a size configuration instruction signal originating from said external device,
the memory module comprising a plurality of elementary blocks (110) arranged in an array according to K rows and P columns, with P an integer greater than or equal to 1, and K an integer greater than 1, and wherein the size of the operand vectors may take a plurality of different values including at least one first size smaller than a second size, and wherein, when the first size is applied, an operand is stored in the memory circuits of a single row of elementary blocks (110) and wherein when the second size is applied an operand is stored in the memory circuits of a plurality of rows of elementary blocks, each memory circuit comprising a portion of the operand of second size and wherein a single vector size is applied at a given time and defined by the configuration register.

2. Memory module according to claim 1, wherein, when the second size is applied, a first operand is stored in a plurality of first elementary blocks belonging to different rows and a second operand is stored in a plurality of second elementary blocks belonging to different rows, et and wherein the operation of transfer of the first operand comprises a plurality of independent operations of transfer from a first elementary block to a second elementary block.

3. Memory module according to claim 1, wherein when the second size is applied, the array of elementary blocks is organized in a plurality of groups of rows, each group of rows being used to store a same portion of a given operand, and wherein data transfers between two elementary blocks of a same column are possible only within a same group of rows.

4. Memory module according to claim 1, wherein:
in each column of the array, the configurable transfer circuits (113) of the elementary blocks (110) in the column are coupled by uplink (VTI-U) and downlink (VTI-D) buses;
each configurable transfer circuit (113) is controllable to transmit data between two uplink buses, between two downlink buses, and/or between the memory circuit (111) of the corresponding elementary block and the two uplink buses and/or the two downlink buses.

5. Memory module (100) according to claim 4, wherein:
in each column of the array, the configurable transfer circuits (113) of any two adjacent elementary blocks (110) of the column are coupled two by two by an uplink bus (VTI-U) and by a downlink bus (VTI-D);
in each elementary block (110) of each column of the array, except for the elementary blocks (110) of the first and last rows of the array, the configurable transfer circuit (113) of the elementary block (110) is controllable to:
a) transmitting on a first data input port (VT_WDATA) of the memory circuit (111) of the elementary block (110) one or the other of:
- a data word received over the downlink bus (VTI-D) coupling the elementary block (110) to the adjacent elementary block (110) of lower rank in the column; and
- a data word received over the uplink bus (VTI-U) coupling the elementary block (110) to the adjacent elementary block (110) of higher rank in the column;
b) transmit over the uplink bus (VTI-U) coupling the elementary block (110) to the adjacent elementary block (110) of lower rank in the column one or the other of:
- a data word received on a first data output port (VT_RDATA) of the memory circuit (111) of the elementary block (110); and
- a data word received over the downlink bus (VTI-U) coupling the elementary block (110) to the adjacent elementary block (110) of higher rank in the column; and
c) transmit over the downlink bus (VTI-D) coupling the elementary block (110) to the adjacent elementary block (110) of higher rank in the column one or the other of:
- a data word received on the first data output port (VT_RDATA) of the memory circuit (111) of the elementary block (110); and
- a data word received over the downlink bus (VTI-D) coupling the elementary block (110) to the adjacent elementary block (110) of lower rank in the column.

6. Memory module (100) according to claim 1, wherein the transfer circuits (113) of the different elementary blocks (110) of the array are connected to the internal control circuit (120) of the memory module via a control bus (TTC).

7. Memory module (100) according to any of claims 1 to 6, wherein the memory circuits (111) of the different elementary blocks (110) of the array are connected to the internal control circuit (120) via a distribution bus (TDI).

8. Memory module (100) according to claim 7, wherein each memory circuit (111) comprises a second data input port (TILE_WDATA) and a second data output port (TILE_RDATA) connected to the distribution bus (TDI).

9. Memory module (100) according to claim 8, wherein the width of the second data input port (TILE_WDATA) and the width of the second data output port (TILE_RDATA) are respectively smaller than or equal to the width of the first data input port (VT_WDATA) and the width of the first data output port (VT_RDATA).

10. Memory module (100) according to claim 9, wherein the width of the second data input port (TILE_WDATA) and the width of the second data output port (TILE_RDATA) are respectively smaller than the width of the first data input port (VT_WDATA) and than the width of the first data output port (VT_RDATA).

11. Memory module (100) according to any of claims 7 to 10, wherein each memory circuit (111) further comprises an address input port connected to the distribution bus (TDI).

12. Memory module (100) according to any of claims 1 to 11, further comprising a general access regulation circuit (130), connected to the internal control circuit (120), the general access regulation circuit performing a tracking of the instructions received on the input-output port of the module and asking if necessary the internal control circuit (120) to wait before requiring the execution of an instruction by an elementary block or before performing a data transfer between a plurality of elementary blocks via said at least one link bus.

13. Memory module (100) according to any of claims 5 to 12, wherein, in each elementary block (110), the transfer circuit (113) of the block comprises first (M1), second (M2), and third (M3) multiplexers each having first and second input ports and an output port and wherein:
- the first multiplexer (M1) has its first and second input ports respectively connected to the downlink bus (VTI-D) coupling the elementary block (110) to the adjacent elementary block (110) of lower rank in the column and to the uplink bus (VTI-U) coupling the elementary block (110) to the adjacent elementary block (110) of higher rank in the column, and its output port connected to the first data input port (VT_WDATA) of the memory circuit (111) of the elementary block (110);
- the second multiplexer (M2) has its first and second input ports respectively connected to the first data output port (VT_RDATA) of the memory circuit (111) of the elementary block (110) and to the uplink bus (VTI-U) coupling the elementary block (110) to the adjacent elementary block (110) of higher rank in the column, and its output port connected to the uplink bus (VTI-U) coupling the elementary block (110) to the adjacent elementary block (110) of lower rank in the column; and
- the third multiplexer (M2) has its first and second input ports respectively connected to the first data output port (VT_RDATA) of the memory circuit (111) of the elementary block (110) and to the downlink bus (VTI-D) coupling the elementary block (110) to the adjacent elementary block (110) of lower rank in the column, and its output port connected to the downlink bus (VTI-D) coupling the elementary block (110) to the adjacent elementary block (110) of higher rank in the column.

14. Memory module (100) according to any of claims 1 to 13, wherein said instruction is transmitted via the data input port (WDATA) and the address input port (ADDR) of the input-output port (123) of the memory module.

15. Memory module (100) according to any of claims 1 to 14, the memory module being further adapted to implementing computing operations between two other operands stored in a same memory circuit (111) of an elementary block (110).

16. System comprising a memory module (100) according to any of claims 1 to 15, and a processing unit coupled to the memory module via the input-output port (123) of the memory module, the memory module being coupled to a bus and behaving as a slave component over said bus.
